# EUROPEAN PATENT SPECIFICATION

(11) **EP 3 761 071 B1**
(45) Date of publication and mention of the grant of the patent: **26.03.2025**
(21) Application number: 19760570.2
(22) Date of filing: 27.02.2019
(51) Int. Cl.: G02B 1/11, G02B 1/14, G09F 9/00, G02F 1/1335, G02B 5/30, G02B 1/115, B32B 27/20, B32B 7/023

(54) **FUNCTIONAL FILM, POLARIZING PLATE AND IMAGE DISPLAY DEVICE**
FUNKTIONELLER FILM, POLARISATIONSPLATTE UND BILDANZEIGEVORRICHTUNG
FILM FONCTIONNEL, PLAQUE DE POLARISATION ET DISPOSITIF D'AFFICHAGE D'IMAGES

(30) Priority: 28.02.2018 JP 2018035425
(43) Date of publication of application: 06.01.2021
(73) Proprietor: Dai Nippon Printing Co., Ltd., Tokyo 162-8001 (JP)
(72) Inventor: KANKE Satoru, Tokyo 162-8001 (JP); TAKACHI Kiyohiro, Tokyo 162-8001 (JP); ISHIDA Kazutoshi, Tokyo 162-8001 (JP); IWASAKI Toshiki, Tokyo 162-8001 (JP); SATO Masaharu, Tokyo 162-8001 (JP); OOMORI Hiroaki, Tokyo 162-8001 (JP); OGAWA Tomohiro, Tokyo 162-8001 (JP)
(74) Representative: Cabinet Beau de Loménie
(86) International application number: PCT/JP2019/007536
(87) International publication number: WO 2019/168021

(56) References cited:
- EP-A1- 3 163 336
- JP-A- 2005 148 376
- JP-A- 2007 086 764
- JP-A- 2007 171 924
- JP-A- 2009 042 647
- US-A1- 2010 292 061
- US-A1- 2011 217 541

## Description

### TECHNICAL FIELD

The present invention relates to a functional film, a polarizing plate, an image display device, and a use of a hard coat film.

### BACKGROUND ART

A functional film is usually provided on an image display screen in image display devices, such as liquid-crystal displays, to protect the screen from scratching and/or to reduce the reflection of external light. An example of such a functional film comprises a hard coat layer and a functional layer, which is closely attached to the hard coat layer and has desired functions such as antireflection function, in that order (see Patent Documents 1 to 3).

The hard coat layer may contain inorganic particles for various reasons, such as adjusting optical properties, achieving a certain pencil hardness, and the like. Among various inorganic particles, silica particles are particularly often used because of their size homogeneity and the abundance of available variations for different purposes. Additionally, an organic layer comprising a resin and formed by a coating technique, or an inorganic layer formed by a sputtering technique or a CVD technique, is used as the functional layer.

### PRIOR ART DOCUMENTS

### Patent Documents

Patent Document 1:JP4913627
Patent Document 2:JP5700903
Patent Document 3:JP6054019

In a hard coat film of US 2011/217541 A1, a hard coat layer includes a cured product of a curable resin composition containing a reactive inorganic fine particle in its surface region being an interface and its vicinity on a side opposite to a transparent substrate film side of the hard coat layer.

EP 3 163 336 A1 shows a low refractive index layer of a resin film comprising a binder, which layer comprises hollow particles distributed in the binder and a fluorine-containing polymer which is immiscible with the hollow particles, which polymer is mostly distributed on the surface of the low refractive index layer.

### SUMMARY OF THE INVENTION

In a functional film comprising a functional layer provided on a hard coat layer, an interface is formed between the hard coat layer and the functional layer. In cases where the functional layer is an organic layer, the organic layer has a resin composition and contents different from those of the hard coat layer to exert functions different from those of the hard coat layer. Thus, it very often occurs that an organic layer formed on a previously cured hard coat layer shows reduced adhesion to the hard coat layer. Additionally, in cases where the functional layer is an inorganic layer, the interface between the hard coat layer and the inorganic layer is a dissimilar interface (an organic/inorganic interface), which allows interfacial debonding to occur more easily than that occurs in a functional layer consisting of an organic layer.

In contrast, image display devices are increasingly used for various applications, including, in addition to conventional television sets, which are mainly used indoors, mobile devices, such as cell phones, which may be used outdoors, and in-vehicle displays, which are exposed to harsher environments than the others are. To address this trend, image display devices are required to have higher durability and reliability. In such a situation, Patent Documents 1 to 3 describe the composition of a hard coat layer, but not the interface between a hard coat layer and a functional layer, which make it uncertain whether excellent adhesion is achieved to a functional layer. Furthermore, a hard coat layer in a functional film may fail to achieve desired optical properties in an attempt to improve the adhesion, which indicates that it is very difficult to achieve both adhesion and desired optical properties. In addition, desired optical properties vary depending on the intended uses and installation sites of functional films, and the like.

The present invention is designed to solve the above problems. That is, an object of the present invention is to provide a functional film which is capable of achieving adhesion between a hard coat layer and a functional layer as well as achieving desired optical properties, and a polarizing plate and an image display device, both of which comprise the above functional film. Another object of the present invention is to provide a use of a hard coat film which is capable of achieving adhesion between a hard coat layer and a functional layer when a functional layer is formed on a surface of the hard coat layer as well as achieving desired optical properties, and a polarizing plate and an image display device, both of which comprise the above hard coat film.

The present invention is defined in the claims.

One aspect of the present invention can provide a functional film which is capable of achieving adhesion between a hard coat layer and a functional layer as well as achieving desired optical properties. Another aspect of the present invention can provide a use of a hard coat film which is capable of achieving adhesion between a hard coat layer and a functional layer when a functional layer is formed on a surface of the hard coat layer as well as achieving desired optical properties. Additionally, still another aspect of the present invention can provide a polarizing plate and an image display device, both of a light-transmitting base material provided on the other side of the hard coat layer, opposite to the side where the functional layer is provided.
[7] A polarizing plate comprising the functional film according to any one of [1] to [6], and a polarizer provided on the other side of the hard coat layer in the functional film, opposite to the side where the functional layer is provided.
[8] A hard coat film comprising at least a hard coat layer that contains a binder resin and plural inorganic particles, wherein the front surface of the hard coat layer constitutes the front surface of the hard coat film, and the hard coat layer has a first region that includes a zone, in which the denseness of the inorganic particles is 60% or more, from the front surface to a depth of 100 nm in the hard coat layer, and a second region, in which the denseness of the inorganic particles is 59% or less, below a depth of 100 nm from the front surface in the hard coat layer.
[9] The hard coat film according to [8], wherein the inorganic particles contain Si element, and wherein the hard coat layer comprises the first region including a first layer zone, in which the sum of the element ratios of Si and O elements is 60% or more, and a second layer zone, in which the sum of the element ratios of Si and O elements is less than 60%.
[10] The hard coat film according to [8] or [9], wherein the hard coat layer has the first region that includes a zone, in which the denseness of the inorganic particles is 70% or more, and the second region, in which the denseness of the inorganic particles is 50% or less.
[11] The hard coat film according to any one of [8] to [10], wherein the maximum aggregation degree of the inorganic particles in the second region is 30% or less.
[12] The hard coat film according to any one of [8] to [11], wherein the film thickness of the hard coat layer is 1 µm or more.
[13] The hard coat film according to any one of [8] to [12], further comprising a light-transmitting base material provided on the back surface opposite to the front surface of the hard coat layer.
[14] A polarizing plate comprising the hard coat film according to any one of [8] to [13], and a polarizer provided on one surface of the hard coat layer.
[15] An image display device, comprising the functional film according to any one of [1] to [6], the polarizing plate according to [7] or [14], or the hard coat film according to any one of [8] to [13].

One aspect of the present invention can provide a functional film which is capable of achieving adhesion between a hard coat layer and a functional layer as well as achieving desired optical properties. Another aspect of the present invention can provide a hard coat film which is capable of achieving adhesion between a hard coat layer and a functional layer when a functional layer is formed on a surface of the hard coat layer as well as achieving desired optical properties. Additionally, still another aspect of the present invention can provide a polarizing plate and an image display device, both of which comprise either a functional film or a hard coat film as described above.

### BRIEF DESCRIPTION OF THE DRAWINGS

FIG. 1 depicts a schematic diagram of a functional film according to the embodiment.
FIG. 2 depicts an enlarged view of a portion of the functional film shown in FIG. 1.
FIG. 3 depicts a schematic diagram of another functional film according to the embodiment.
FIG. 4 depicts a schematic diagram of a polarizing plate according to the embodiment.
FIG. 5 depicts a schematic diagram of an image display device according to the embodiment.
FIG. 6 is a scanning transmission electron micrograph showing a cross-section of a hard coat layer in a functional film according to Example 1.
FIG. 7 is a binarized image of the functional film according to Example 1 processed with spreadsheet software.

### DETAILED DESCRIPTION OF THE INVENTION

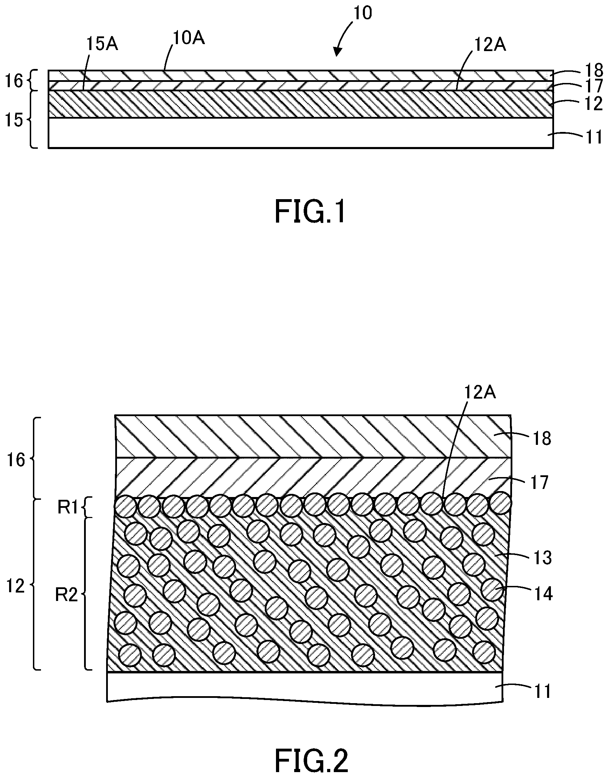

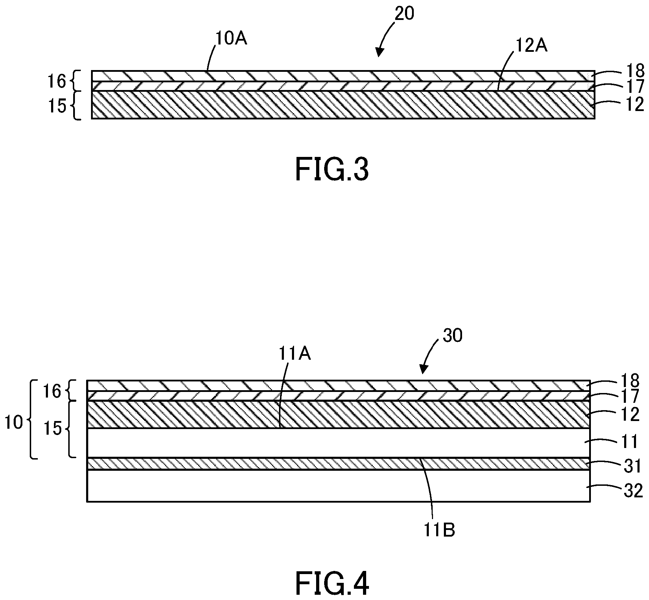

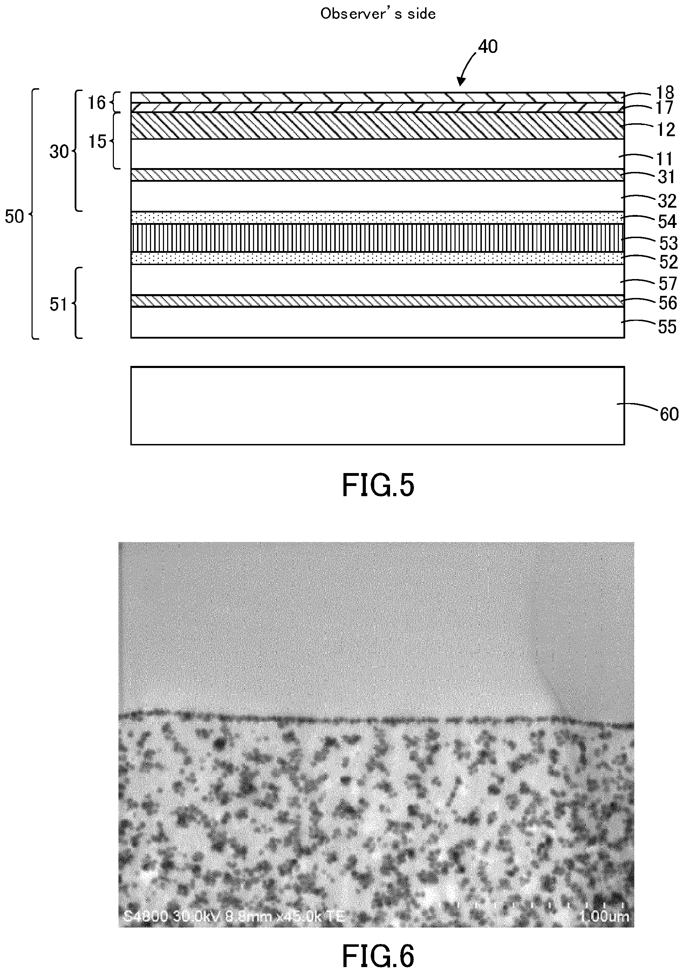

A functional film, a polarizing plate and an image display device according to the embodiment of the present invention will be described below with reference to the drawings. In this specification, the terms "film" and "sheet" are not distinguished from each other on the basis of the difference of names alone. For example, the term "film" is thus used to refer inclusively to a member called "sheet." FIG. 1 depicts a schematic diagram of a functional film according to the embodiment, and FIG. 2 depicts an enlarged view of a portion of the functional film shown in FIG. 1, and FIG. 3 depicts a schematic diagram of another functional film according to the embodiment. FIG. 4 depicts a schematic diagram of a polarizing plate according to the embodiment, and FIG. 5 depicts a schematic diagram of an image display device according to the embodiment.

### <<<Functional Film and Hard Coat Film>>>

The functional film 10 shown in FIG. 1 comprises a hard coat film 15, which includes a light-transmitting base material 11 and a hard coat layer 12 containing a binder resin 13 and plural inorganic particles 14, and a functional layer 16 that is closely attached to the front surface 15A of the hard coat film 15 (the front surface 12A of the hard coat layer 12), in that order. The functional film 10 and the hard coat film 15 comprise the light-transmitting base material 11, but may comprise no light-transmitting base material, as described below. Additionally, the functional film and the hard coat film may further comprise a resin-based underlayer between a light-transmitting base material and a hard coat layer, to enhance the adhesion between the light-transmitting base material and the hard coat layer.

In the functional film 10 and the hard coat film 15, the haze value is important though the haze varies between different applications. In cases where those films are used for light transmission but require no antiglare properties, those films are generally preferred to have a haze value (total haze value) of 1.0% or less. In this respect, the functional film 10 and the hard coat film 15 with a haze value of 1.0% or less can have excellent transparency. In this case, the functional film 10 and the hard coat film 15 more preferably have a haze value of 0.9% or less, most preferably 0.8% or less. In contrast, when those films are required to have antiglare properties, a different haze value is required to balance the haze value with the antiglare properties. Specifically, it is often the case, for example, that the haze value is designed to range from 2% or more to 45% or less and the 60 degree gloss value is designed to range from 20% or more to 130% or less. It is known that a higher haze value tends to correlate with a higher antiglare effect. However, a high haze value in films with antiglare properties is not simply desirable, but different haze values are of interest depending on the intended uses and installation sites of either functional films or hard coat films. Therefore, it is difficult to determine a uniquely optimal haze value range.

The above-described haze value can be measured using a haze meter (product name: "HM-150"; manufactured by Murakami Color Research Laboratory Co., Ltd.) by a method in accordance with JIS K7136: 2000. The above haze value is defined as the arithmetic mean of three measurements obtained by setting a cut piece of the functional film with a size of 50 mm × 50 mm without generating any curl or wrinkle and without leaving any dirt such as fingerprints or dust to measure the haze value, and then repeating the measurement three times on one functional or hard coat film. The phrase "measured three times" as used herein should refer not to measuring at the same position three times but to measuring at three different positions. The functional film 10 and the hard coat film 15 are visually observed to have a flat front surface 10A and also have a laminated layer, such as the hard coat layer 12, with a smooth surface, and also have a deviation in film thickness within ±10%. Accordingly, it is considered that an approximate average haze value of the whole functional or hard coat film can be obtained by measuring the haze value at three different positions on the piece cut out from the functional film. The deviation in haze value is within ±10% even if a measurement object has a size as large as 1 m × 3000 m or as large as a 5-inch smartphone. If a piece having the same size as described above cannot be cut out from the functional film, a piece having a size equal to or greater than a diameter of 21 mm is required because, for example, the HM-150 haze meter has an entrance port aperture with a diameter of 20 mm for use in the measurement. Thus, a piece having a size of 22 mm × 22 mm or larger may be cut out from the functional film or the hard coat film as appropriate. If the functional film or the hard coat film is small in size, the film is gradually shifted or turned in such an extent that the light source spot is within the piece of film to secure three measurement positions.

In cases where an additional film, such as polarizing plate, is provided on the functional layer film or the hard coat film through an adhesive or adhesion layer, the haze value should be measured after removing the additional film and the adhesive or adhesion layer and further wiping out debris derived from the adhesive or adhesion layer with an alcohol. The additional film can be removed, for example, as follows. First of all, a laminate consisting of either the functional film or the hard coat film attached to an additional film through an adhesive or adhesion layer is heated with a hair dryer, and is slowly separated by inserting a cutter blade into a possible interface between either the functional film or the hard coat film and the additional film. By repeating such a process of heating and separation, the adhesive or adhesion layer and the additional film can be removed. Even if such a removal process is performed, measurement of the haze value is not significantly affected.

The above-described 60 degree gloss value can be measured using a precision gloss meter (product name: "GM-26D"; manufactured by Murakami Color Research Laboratory Co., Ltd.) by a method in accordance with JIS Z8741: 1997. The above-described 60 degree gloss value should be measured by cutting out a piece with a size of 50 mm × 50 mm from either the functional film or the hard coat film, and then placing the piece of either the functional film or the hard coat film in the precision gloss meter for the measurement, while keeping the back surface of the film closely attached to a resin plate in lusterless black color by vacuuming the air. Moreover, the above-described 60 degree gloss value is defined as the arithmetic mean of three measurements obtained by repeating the measurement three times on one functional or hard coat film.

The functional film 10 and the hard coat film 15 preferably have a total light transmittance of 85% or more. The functional film 10 and the hard coat film 15 with a total light transmittance of 80% or more can allow sufficient light transmittance. The functional film 10 more preferably has a total light transmittance of 88% or more, most preferably 90% or more.

The above-described total light transmittance can be measured using a haze meter (product name: "HM-150"; manufactured by Murakami Color Research Laboratory Co., Ltd.) by a method in accordance with JIS K7361-1: 1997. The above-described total light transmittance is defined as the arithmetic mean of three measurements obtained by setting a cut piece of either the functional film or the hard coat film with a size of 50 mm × 50 mm without generating any curl or wrinkle and without leaving any dirt such as fingerprints or dust to measure the total light transmittance, and then repeating the measurement three times on one functional or hard coat film. The functional film 10 and the hard coat film are visually observed to have a flat front surface 10A and also have a laminated layer, such as the hard coat layer 12, with a smooth surface, and also have a deviation in film thickness within ±10%. Accordingly, it is considered that an approximate average total light transmittance of the whole functional or hard coat film can be obtained by measuring the total light transmittance at three different positions on the piece cut out from the functional film. The deviation in total light transmittance is within ±10% even if a measurement object has a size as large as 1 m × 3000 m or as large as a 5-inch smartphone. If a piece having the same size as described above cannot be cut out from either the functional film or the hard coat film, a piece having a size of 22 mm × 22 mm or larger may be cut out from the functional film as appropriate. If the functional film or the hard coat film is small in size, the film is gradually shifted or turned in such an extent that the light source spot is within the piece of film to secure three measurement positions.

Additionally, in cases where an additional film, such as polarizing plate, is provided on the functional film or the hard coat film through an adhesive or adhesion layer, the total light transmittance of the functional film is measured after removing the additional film and the adhesive or adhesion layer in the same manner as described above. Even if such a removal process is performed, measurement of the total light transmittance is not significantly affected.

The front surface 10A of the functional film 10 (the front surface of the functional layer 16) or the front surface 15A of the hard coat film 15 preferably has a hardness (pencil hardness) of B or harder, more preferably H or harder, when measured by the pencil hardness test specified by JIS K5600-5-4: 1999. The pencil hardness test should be carried out as follows: a piece of either the functional film or the hard coat film is cut to a size of 50 mm × 50 mm and fixed with Cello-tape^{®}, manufactured by Nichiban Co., Ltd., over a glass plate without generating any fold or wrinkle; and a pencil is moved over the surface of the piece of the film at a speed of 1 mm/sec while a load of 1 kg is applied to the pencil. The grade of the hardest pencil that does not scratch the surface of either the functional film or the hard coat film during the pencil hardness test is determined as the pencil hardness of the film. A plural number of pencils with different hardness are used for the measurement of pencil hardness, and the pencil hardness test is repeated five times on each pencil. In cases where no scratch is made on the surface of either the functional film or the hard coat film with a pencil with specific hardness in four or more out of the five replicates, the pencil with the hardness is determined to make no scratch on the surface of either the functional film or the hard coat film. The above-described scratch refers to a scratch which is visibly detectable when the surface of either the functional film or the hard coat film subjected to the pencil hardness test is observed under transmitting fluorescent light.

The intended uses of the functional film 10 and the hard coat film 15 are not specifically limited. However, in cases where either of the films functions as an optical film, examples of the intended uses of the functional film 10 and the hard coat film 15 include image display devices for personal computers (PCs) including, for example, notebook personal computers, and those for smartphones, tablet terminals, wearable terminals, digital signage systems, televisions, and automotive navigation systems. Additionally, the functional film 10 may be used as a packaging material.

The functional film 10 and the hard coat film 15 can be cut into a desired size or may be rolled. In cases where either the functional film 10 or the hard coat film 15 is cut into a desired size, the cut piece of either the functional film or the hard coat film is not limited to a particular size, and the size of the film is appropriately determined depending on the intended use (for example, depending on the display size of an image display device when the film is used in the image display device). Specifically, the functional film 10 and the hard coat film 15 may be, for example, 2.8 inches or more and 500 inches or less in size. The term "inch" as used herein should refer to the length of a diagonal when the functional film or the hard coat film is rectangular, and to the length of a diameter when the functional film or the hard coat film is circular, and to the average of major and minor axes when the functional film or the hard coat film is elliptical. In cases where the functional film or the hard coat film is rectangular here, the aspect ratio of the functional film is not specifically limited, which refers to the above-described size in inch determined for the functional film, provided that no problem is found in the functional film used for the display screen of an image display device. Examples of the aspect ratio include height-to-width ratios of 1:1, 4:3, 16:10, 16:9, and 2:1. However, particularly in films used for vehicle displays and digital signage systems which are rich in designs, the aspect ratio is not limited to the above-described aspect ratios. Additionally, in cases where the functional film 10 or the hard coat film 15 is large in size, the functional film or the hard coat film will be trimmed to the A5 size (148 mm × 210 mm) starting at an arbitrary position and then trimmed to fit size requirements of each measurement item.

### <<Light-Transmitting Base Material>>

The light-transmitting base material 11 is not specifically limited, provided that it is a base material with light-transmitting properties. Examples of the base material include polyester base materials, cellulose acetate base materials, cycloolefin polymer base materials, polyethersulfone base materials, polycarbonate base materials, polyamide base materials, polyimide base materials, polyolefin base materials, acrylic base materials, polyvinyl chloride base materials, polyvinylidene chloride base materials, polystyrene base materials, polyvinyl alcohol base materials, polyarylate base materials, and polyphenylene sulfide base materials. Among those, cellulose acetate base materials and acrylic base materials are preferred from the viewpoint of reducing interference fringes caused by birefringence and of forming adhesion with a hard coat layer. The light-transmitting base material 11 may contain, for example, additives, in addition to a resin.

Examples of the polyester base material include base materials containing at least one of polyethylene terephthalate (PET), polypropylene terephthalate (PEN), polybutylene terephthalate, and polyethylene naphthalate as a component.

Examples of the cellulose acetate base material include cellulose triacetate and cellulose diacetate base materials. The cellulose triacetate base material is a base material capable of having an average light transmittance of 50% or more in the visible light range from 380 to 780 nm. The cellulose triacetate base material preferably has an average light transmittance of 70% or more, further preferably 85% or more.

The cellulose triacetate base material may include an ester formed from cellulose and acetic acid along with a fatty acid, such as cellulose acetate propionate or cellulose acetate butyrate, as well as pure cellulose triacetate. Additionally, these cellulose triacetates may include other lower cellulose fatty acid esters, such as cellulose diacetate, as necessary.

Examples of the cycloolefin polymer base material include base materials composed of polymers of, for example, norbornene monomers and those of monocycloolefin monomers. Commercially available cycloolefin polymers include, for example, ZEONEX and ZEONOR (norbornene-based resins) manufactured by ZEON Corporation, SUMILITE FS-1700 manufactured by Sumitomo Bakelite Co., Ltd., ARTON (modified norbornene-based resin) manufactured by JSR Corporation, APEL (cyclic olefin copolymer) manufactured by Mitsui Chemicals Inc., Topas (cyclic olefin copolymer) manufactured by Ticona, and OPTREZ OZ-1000 series (alicyclic acrylic resin) manufactured by Hitachi Chemical Co., Ltd.

Examples of the polycarbonate base material include bisphenol-based (for example, bisphenol A-based) aromatic polycarbonate base materials, and aliphatic polycarbonate base materials, such as diethylene glycol bis(allyl carbonate).

Examples of the acrylic base material include base materials composed of resins that are obtained by polymerizing monomers such as (meth)acrylic ester, acrylamide, acrylonitrile, (meth)acrylic acid, and derivatives thereof. Among those, poly(methyl methacrylate) (PMMA), copolymers containing methyl methacrylate monomers as a main component, and styrene-methyl methacrylate copolymer are preferred from the viewpoint of transparency and weather resistance.

The light-transmitting base material 11 preferably has a thickness of 20 µm or more and 200 µm or less. The light-transmitting base material 11 with a thickness of 20 µm or more can provide a functional film without any wrinkle and with excellent pencil hardness, while the light-transmitting base material 11 with a thickness of 200 µm or less can provide enough flexibility to allow a functional film to be rolled. The thickness of the light-transmitting base material can be determined by using a scanning electron microscope (SEM) to acquire a cross-sectional image of the light-transmitting base material, measuring the thickness of the light-transmitting base material at 20 different locations within the cross-sectional image, and calculating the arithmetic mean of the measured thickness values at the 20 locations.

### <<Hard Coat Layer>>

In the hard coat film 15, the front surface 12A of the hard coat layer 12 constitutes the front surface 15A of the hard coat film 15. The hard coat layer 12 contains a binder resin 13 and plural inorganic particles 14. The hard coat layer 12 may contain, in addition to the binder resin 13 and the inorganic particles 14, components such as an ultraviolet absorber, a leveling agent, and a silane coupling agent.

The hard coat layer 12 has a monolayer structure, but may have a multilayer structure composed of two or more layers. The term "hard coat layer" as used herein should refer to a layer with a light-transmitting property and a Martens hardness of 100 MPa or more. In this specification, the term "Martens hardness" refers to a hardness measured when an indenter is pressed into a specimen to a depth of 500 nm in a nanoindentation hardness test. Measurement of the Martens hardness based on the above-described nanoindentation technique will be performed on a measurement sample using a "TI950 TriboIndenter" manufactured by Hysitron, Inc. Specifically, a piece of a functional film with a size of 1 mm × 10 mm is cut out from the functional film and embedded in an embedding resin to prepare a block, and homogeneous sections having a thickness of 70 nm or more and 100 nm or less and having no openings or the like are sliced from the block according to a commonly used sectioning technique. For the preparation of sections, an "Ultramicrotome EM UC7" (Leica Microsystems GmbH) and the like can be used. Then, the block remaining after slicing the homogeneous sections with no openings or the like is used as a measurement sample. Subsequently, in the cross-section of the measurement sample obtained after slicing the above-described sections, a Berkovich indenter (trigonal pyramid) as the above-described indenter is pressed into the hard coat layer at center of the cross-section to a depth of 500 nm, held at the position for a certain period of time to relax the residual stress, and then unloaded, under the following measurement conditions to measure the maximum load after the relaxation, and the maximum load Pₘₐₓ (µN) and the area of the 500 nm deep indentation A (nm²) are used to calculate the Martens hardness from the value of Pₘₐₓ/A. The Martens hardness is defined as the arithmetic mean of measured values at 10 different locations.

### (Measurement conditions)

· Loading speed: 10 nm/sec
· Retention time: 5 sec
· Unloading speed: 10 nm/sec
· Measurement temperature: 25°C

The hard coat layer 12 preferably has a film thickness of 1 µm or more. The hard coat layer 12 with a film thickness of 1 µm or more can retain sufficient hardness. More preferably, the minimum film thickness of the hard coat layer 12 is 2 µm or more. The maximum film thickness of the hard coat layer 12 is preferably 20 µm or less, more preferably 10 µm or less, to inhibit reduction in workability due to extensive increase in the film thickness.

The film thickness of the hard coat layer is defined as the arithmetic mean of film thickness values measured at 20 different locations, where a cross-section of the hard coat layer is imaged using a scanning transmission electron microscope (STEM) or a transmission electron microscope (TEM), and the film thickness of the hard coat layer is measured at the 20 locations within the image of the cross-section. A specific method of acquiring cross-sectional images is described below. First of all, a cut piece of either the functional film or the hard coat film with a size of 15 mm × 10 mm is fixed on a resin plate, and is sliced with a Ultramicrotome EM UC6 (manufactured by Leica Microsystems GmbH) to leave a portion of the film with a trimming width of 300 µm and a height of 80 µm, and the remaining portion of the film is further sliced in the thickness direction with a DiATOME diamond knife ULTRA to produce homogeneous sections having a thickness of 70 nm or more and 100 nm or less and having no openings or the like. For the preparation of sections, an Ultramicrotome EM UC7 (Leica Microsystems GmbH) or the like may be used. Then, the block remaining after slicing the homogeneous sections with no openings or the like is used as a measurement sample. The measurement sample may be prepared by a commonly used method, in which embedding in resin is performed. Subsequently, cross-sectional images of the measurement sample are acquired using a scanning electron microscope (STEM) (product name: "S-4800"; manufactured by Hitachi High-Technologies Corporation). The cross-sectional images are acquired using the above-described S-4800 by setting the detector to "TE," the accelerating voltage to "5 kV," and the emission current to "10 µA." The focus, contrast, and brightness are appropriately adjusted at a magnification of 5,000 to 200,000 times, so that each layer can be identified by observation. Furthermore, the beam monitor aperture, the objective lens aperture, and the WD may be respectively set to "3," "3," and "8 mm," in acquisition of cross-sectional images using the above-described S-4800. For the measurement of the film thickness of the hard coat layer, it is important that the contrast at the interfacial boundary between the hard coat layer and another layer (for example, the light-transmitting base material) can be observed as clearly as possible when the cross-section is observed. In cases where the interfacial boundary is hardly observed due to lack of contrast, a staining process may be applied because interfacial boundaries between organic layers become easily observed by staining with osmium tetraoxide, ruthenium tetraoxide, phosphotungstic acid, or the like. Additionally, higher magnification may make it more difficult to find the interfacial contrast. In that case, the observation is also carried out with low magnification. For example, the observation is carried out with two magnifications consisting of a higher magnification, such as 25,000 or 50,000 times, and a lower magnification, such as 50,000 or 100,000 times, to determine the above arithmetic means at both magnifications, which are further averaged to determine the film thickness of the hard coat layer.

### <Binder Resin>

The binder resin 13 contains a polymerized product (a cured product) of a polymerizable compound (a curable compound). The polymerizable compound refers to a molecule having at least one polymerizable functional group, and may be either a radiation-polymerizable compound, which is polymerized by exposure to ionizing radiation, or a thermally polymerizable compound, which is polymerized by exposure to heat. Examples of the polymerizable functional group include ethylenic unsaturated groups such as (meth)acryloyl group, vinyl group, and allyl group. Both "acryloyl group" and "methacryloyl group" are meant by the word "(meth)acryloyl group." Additionally, the ionizing radiation includes visible light, ultraviolet light, X-rays, electron beams, α-rays, β-rays, and γ-rays.

In addition to a first polymerizable monomer as described above, a second polymerizable monomer, oligomer and/or prepolymer may be contained as a polymerizable compound.

The second polymerizable monomer is preferably a polyfunctional (meth)acrylate. Examples of the above-described polyfunctional (meth)acrylate include trimethylolpropane tri(meth)acrylate, tripropylene glycol di(meth)acrylate, diethylene glycol di(meth)acrylate, dipropylene glycol di(meth)acrylate, pentaerythritol tri(meth)acrylate, pentaerythritol tetra(meth)acrylate, dipentaerythritol hexa(meth)acrylate, 1,6-hexanediol di(meth)acrylate, neopentyl glycol di(meth)acrylate, trimethylolpropane tri(meth)acrylate, ditrimethylolpropane tetra(meth)acrylate, dipentaerythritol penta(meth)acrylate, tripentaerythritol octa(meth)acrylate, tetrapentaerythritol deca(meth)acrylate, isocyanuric acid tri(meth)acrylate, isocyanuric acid di(meth)acrylate, polyester tri(meth)acrylate, polyester di(meth)acrylate, bisphenol di(meth)acrylate, diglycerol tetra(meth)acrylate, adamantyl di(meth)acrylate, isobornyl di(meth)acrylate, dicyclopentane di(meth)acrylate, tricyclodecane di(meth)acrylate, ditrimethylolpropane tetra(meth)acrylate, and those compounds modified with PO, EO, caprolactone, or the like.

Among those polyfunctional polymerizable compounds, polymerizable compounds with three to six functional groups trifunctional, such as pentaerythritol triacrylate (PETA), dipentaerythritol hexaacrylate (DPHA), pentaerythritol tetraacrylate (PETTA), dipentaerythritol pentaacrylate (DPPA), trimethylolpropane tri(meth)acrylate, tripentaerythritol octa(meth)acrylate, and tetrapentaerythritol deca(meth)acrylate, are preferred in terms of the ability to achieve the above-described Martens hardness in a suitable manner.

The second polymerizable compound may further comprise, in addition to the polyfunctional monomer, a monofunctional (meth)acrylate monomer for the purpose of, for example, adjusting the hardness of the resin and the viscosity of the composition. Examples of the above-described monofunctional (meth)acrylate monomer include hydroxyethyl acrylate (HEA), glycidyl methacrylate, methoxypolyethylene glycol (meth)acrylate, isostearyl (meth)acrylate, 2-acryloyloxyethyl succinate, acryloyl morpholine, N-acryloyloxyethyl hexahydrophthalimide, cyclohexyl acrylate, tetrahydrofuryl acrylate, isobornyl acrylate, phenoxyethyl acrylate, and adamantyl acrylate.

Examples of the polymerizable oligomer or prepolymer include oligomers or prepolymers of urethane (meth)acrylate, polyester (meth)acrylate, epoxy (meth)acrylate, melamine (meth)acrylate, polyfluoroalkyl (meth)acrylate, silicone (meth)acrylate, and the like. These polymerizable oligomers or prepolymers may be used individually or in combination of two or more.

The weight average molecular weight of the above-described first or second polymerizable monomer is preferably less than 1,000, more preferably 200 or more and 800 or less, in terms of improving the hardness of the hard coat layer. Additionally, the weight average molecular weight of the above-described polymerizable oligomer is preferably 1,000 or more and 20,000 or less, more preferably 1,000 or more and 10,000 or less, and further preferably 2,000 or more and 7,000 or less. In this specification, the term "weight average molecular weight" refers to a molecular weight given in terms of polystyrene equivalent molecular weight, which is obtained from the monomer or oligomer dissolved in a solvent such as tetrahydrofuran (THF) and analyzed by a conventionally known method of gel permeation chromatography (GPC).

The binder resin 13 preferably contains elemental phosphorus (P). The presence of elemental phosphorus in the binder resin 13 can enhance the adhesion between the binder resin 13 and the inorganic particles 14. Whether or not the binder resin 13 contains elemental phosphorus can be checked by means of X-ray photoelectron spectroscopy (XPS) or electron spectroscopy for chemical analysis (ESCA).

In cases where elemental phosphorus (P) is contained in the binder resin 13, the element ratio of elemental phosphorus is preferably 0.1% or more in the front surface 12A of the hard coat layer 12. If the element ratio of elemental phosphorus is 0.1% or more in the front surface 12A, the adhesion between the hard coat layer 12 and the functional layer 16 can be further enhanced. The element ratios of elements in a first surface of the hard coat layer can be determined by XPS or ESCA. The minimum element ratio of elemental phosphorus is more preferably 0.3% or more, while the maximum element ratio of elemental phosphorus is preferably 10% or less to inhibit increase in haze due to aggregation of phosphorus-containing components during coating process.

Use of a phosphate monomer in the binder resin 13 can allow the binder resin 13 to contain elemental phosphorus. The phosphate monomer comprises phosphate groups and polymerizable functional groups. Examples of the phosphate monomer include ethylene oxide-modified phosphate (meth)acrylate, ethylene oxide-modified phosphate di(meth)acrylate, dimethyl phosphate-ethyl acrylate, diethyl phosphate-ethyl acrylate, 2-acryloyloxyethyl phosphate, bis(acryloyloxyethyl) phosphate, tris(acryloyloxyethyl) phosphate, 2-methacryloyloxyethyl phosphate, bis(methacryloyloxyethyl) phosphate, and ethoxylated tri(meth)acrylate phosphate. Phosphate groups in the phosphate monomers can interact with the inorganic particles via hydrogen bonds and polymerizable functional groups in the phosphate monomers can be associated with the polymerizable compound, respectively, to enhance the adhesion between the binder resin 13 and the inorganic particles 14, which can in turn reduce the risk of interfacial debonding between the hard coat layer 12 and the functional layer 16 to a greater degree.

### <Inorganic Particles>

The hard coat layer 12 comprises a first region R1 (see FIG. 2) that includes a layer zone, in which the denseness of the inorganic particles 14 is 60% or more (hereinafter referred to as "high-denseness layer zone"), from the front surface 12A to a depth of 100 nm in the hard coat layer 12, and a second region R2 (see FIG. 2), in which the denseness of the inorganic particles 14 is 59% or less, below a depth of 100 nm from the front surface 12A in the hard coat layer 12. In this specification, the "denseness of inorganic particles" refers to an indicator that expresses the denseness of the inorganic particles in the direction orthogonal to the film thickness direction of the hard coat layer in each of the first and second regions. Thus, a higher denseness of the inorganic particles 14 in the high-denseness layer zone within the first region R1 than the denseness of the inorganic particles 14 in the second region R2 indicates that, in the direction orthogonal to the film thickness direction of the hard coat layer 12, the inorganic particles 14 existing in the high-denseness layer zone within the first region R1 are more in number than those in the second region R2. As described below, the denseness of the inorganic particles is determined for each row, where a row comprises plural cells arranged in the direction orthogonal to the film thickness direction of the hard coat layer, and this causes a zone within the first region, in which the denseness of the inorganic particles is 60% or more, to appear as a layer. In consideration of achieving adhesion between the hard coat layer 12 and the functional layer 16 as well as desired optical properties to a greater degree, the maximum denseness of the inorganic particles 14 is preferably 70% or more in the high-denseness layer zone within the first region R1 and the denseness of the inorganic particles 14 is preferably 50% or less in the second region R2.

The denseness of the inorganic particles in the first region can be determined by the following method. First of all, a cross-sectional image of the hard coat layer captured using a transmission electron microscope (TEM) or a scanning transmission electron microscope (STEM) at a magnification of 30,000 to 100,000 times is acquired and processed by an image processing software program (product name: "ImageJ"; created by the National Institute of Health, United States) to binarize each cell in the image into black/white. In this respect, the size of the binarized image is preferably 640 × 480 pixels or more. In the cross-sectional image captured by the TEM or STEM, the inorganic particles with a higher density are shown in black color because a less intense electron beam is transmitted through the inorganic particles, and the binder resin, whose density is lower than that of the inorganic particles, is shown in white color. Thus, after the binarization, the inorganic particles are expressed as black regions, and the binder resin is expressed as white regions. Cells with values closer to values corresponding to white and black colors will be classified as representing the area occupied by the resin and the area occupied by the particles, respectively, where the average value of all the cells is set as a threshold for the classification. In cells appearing in the binarized image, each cell on a row is classified as belonging to a black or white region, where a row comprises plural cells arranged in the direction orthogonal to the film thickness direction of the hard coat layer, to determine the percentage of cells determined as belonging to black regions in the total number of cells on the row. The entire first region is analyzed, and the presence of a high-denseness layer zone in the first region can be confirmed if there is a zone in which the denseness is 60% or more. A row is not necessarily needed to be analyzed in the direction orthogonal to the film thickness direction across the entire width of the obtained TEM or STEM image, provided that the row includes a number of cells that is large enough to provide sufficient analytical accuracy. Specifically, 100 cells or more would be many enough to provide high accuracy.

The denseness of the inorganic particles in the second region is also determined in the same manner as for the denseness of the inorganic particles in the first region, except that the denseness of the inorganic particles in the second region is determined by obtaining the above-described percentage for at least five rows at different depths in the second region and calculating the arithmetic mean of the obtained percentages.

The method of acquiring a cross-sectional image of the hard coat layer with a STEM for determination of the denseness of the inorganic particles 14 is the same as the method of acquiring a cross-sectional for the determination of film thickness described in the section of Hard Coat Layer, except for the magnification.

The above-described binarization is performed with an image processing software program (product name: "ImageJ"; created by the National Institute of Health, United States), and is specifically performed by the following procedure. First of all, a cross-sectional image is acquired by the above-described software program, to add a specific value representing a black-and-white gradation of each pixel in the image to a cell in a spreadsheet, where one pixel corresponds to one cell. In this step, the number of black-and-white gradations should be as many as possible. Specifically, the presence of 128 or more gradations is desirable for the following data analysis. This binarization to generate a black/white image is not only performed by a particular software program, but may also be performed by a calculation using a macro in spreadsheet software.

The inorganic particles 14 are silica particles, in view of achieving excellent hardness. In cases where the functional layer 16 is an inorganic layer, at least a portion of the inorganic particles 14 are preferably located in the interface between the hard coat layer 12 and the functional layer 16, and directly attached to the functional layer 16, as shown in FIG. 2. The direct attachment of the inorganic particles 14 to the functional layer 16 in the interface forms an inorganic/inorganic interface along the interface between the inorganic particles 14 and the functional layer 16, which can further enhance the adhesion between the hard coat layer 12 and the functional layer 16. Whether or not inorganic particles are located in the interface between a hard coat layer and a functional layer can be confirmed by observing a cross-section of the hard coat layer under a scanning transmission electron microscope (STEM) or a transmission electron microscope (TEM). As a method of preparing a cross-section of the hard coat layer, for example, oblique cutting with a surface-interface cutting analysis system (SAICAS) or slicing with a microtome is available. Additionally, a cross-section of the functional layer prepared by cutting with, for example, a utility knife or a microtome may be exposed using a xenon weather resistance testing machine to a study environment for a long period of time, and then exposed to an additional wet and warm environment or treated by applying a solvent such as an alcohol to the cross-section and its neighborhood to forcibly separate the functional layer and then to observe whether inorganic particles are located in the interface between the hard coat layer and the functional layer, with the functional layer separated off from the hard coat layer.

In the invention, the hard coat layer 12 includes the inorganic particles 14 containing Si element and comprises the first region R1 including a first layer zone, in which the sum of the element ratios of Si and O elements is 60% or more, and a second layer zone, in which the sum of the element ratios of Si and O elements is less than 60%. The first region R1 including a first layer zone in which the sum of the element ratios of Si and O elements is 60% or more can further enhance the adhesion between the hard coat layer 12 and the functional layer 16. Moreover, the first region R1 including a second layer zone in which the sum of the element ratios of Si and O elements is less than 60% can further inhibit deterioration in optical properties, which occurs due to the presence of too many inorganic particles 14. The element ratios of Si and O elements in the first and second layer zones are determined using a scanning X-ray photoelectron spectrometer (product name: "Quantum 2000"; manufactured by ULVAC-PHI Inc.) under the following measurement conditions, where the hard coat layer is etched and analyzed every 5 nm in the depth direction of the hard coat layer to determine the element ratios of Si and O elements.

### (Measurement conditions)

· X-ray conditions: AI, mono, diameter of 200 µm × 30W, 15kV
· Photoelectron detector angle: 45°
· Etching conditions: 2kV, raster of 2 × 2

The maximum aggregation degree of the inorganic particles 14 in the second region R2 is 30% or less. In cases where the maximum aggregation degree of the inorganic particles 14 in the second region R2 is 30% or less, the deterioration of optical properties can be further inhibited. More preferably, the maximum aggregation degree of the inorganic particles 14 in the second region R2 is 20% or less, or 10% or less (a smaller percentage is more preferred). In this specification, the phrase "the maximum aggregation degree of inorganic particles in the second region" means the largest aggregation degree among the aggregation degrees of inorganic particles determined for multiple rows, wherein the ratio of the number of inorganic particles in an aggregate, which is formed from three or more inorganic particles adjacent to each other, to the total number of inorganic particles in a row is defined as the aggregation degree of the inorganic particles in the row, and the aggregation degree of the inorganic particles is determined for the multiple rows (for example, any number of rows, from 10 to 30 rows), and wherein a row is defined as a zone in the second region which extends in the direction orthogonal to the film thickness direction of the hard coat layer and is observed when a cross-section of the hard coat layer is observed. Specifically, the maximum aggregation degree of the inorganic particles 14 in the second region R2 is determined as follows. In cells appearing in a binarized image, the ratio of a series of cells connected to each other in a length of three or more times the primary particle size of the inorganic particle to the total number of cells in a row is first determined to calculate the aggregation degree for the row, where a row comprises plural cells arranged in the direction orthogonal to the film thickness direction of the hard coat layer, and a series of cells connected to each other in a length of three or more times the primary particle size of the inorganic particle is considered as an aggregate of cells. Then, the aggregation degree of inorganic particles is determined for multiple rows (for example, any number of rows, from 10 to 30 rows), and the largest aggregation degree among the aggregation degrees of inorganic particles determined for the multiple rows is defined as the maximum aggregation degree. The above-described "primary particle size" refers to the smallest length among the diameters, widths, depths, and heights of the inorganic particles.

The inorganic particles may be spherical particles but are preferably deformed particles. Spherical particles may be combined with deformed particles. Because the above-described deformed particle has a larger surface area than that of a spherical particle, the presence of such deformed particles increases the adhesion area with, for example, the above-described polyfunctional compound and can thereby improve the hardness of the above-described hard coat layer. Observation of a cross-section of the hard coat layer under a transmission electron microscope (TEM) or a scanning transmission electron microscope (STEM) can determine whether inorganic particles contained in the hard coat layer are deformed particles or not. In this specification, the "spherical particle" refers to, for example, a spherical or ellipsoidal particle, while "deformed particle" refers to a particle with a randomly rough surface as observed on potato tubers (having an aspect ratio of 1.2 or more and 40 or less when a cross-section is observed).

The average primary particle size of the inorganic particles 14 is preferably 5 nm or more and 100 nm or less. The inorganic particles 14 with an average primary particle size of 5 nm or more can be easily manufactured, while the inorganic particles 14 with an average primary particle size of 100 nm or less will prevent the hard coat layer 12 from forming highly rough surfaces. In cases where the inorganic particles are spherical particles, the average primary particle size of the inorganic particles is defined as the arithmetic mean of the primary particle sizes of 20 inorganic particles, where the primary particle sizes of the 20 inorganic particles are measured from cross-sectional images of inorganic particles acquired using a transmission electron microscope (TEM) or a scanning transmission electron microscope (STEM) at a magnification of 40,000 to 200,000 times. Additionally, in cases where the inorganic particles are deformed particles, the average primary particle size of the inorganic particles is defined as the arithmetic mean of the primary particle sizes of 20 inorganic particles, which are determined by measuring the maximum (major axis) and minimum (minor axis) values of the distance between two points on the circumference of an inorganic particle within a cross-sectional image of the hard coat layer captured using a transmission electron microscope (TEM) or a scanning transmission electron microscope (STEM), averaging the obtained values to determine the primary particle size of the inorganic particle, and repeating the measurement for the 20 inorganic particles.

The hardness (Martens hardness) of the hard coat layer 12 can be controlled by adjusting the size of and the added amount of the inorganic particles 14. For example, in cases where the inorganic particles 14 have a diameter of 5 nm or more and 100 nm or less, the content of the inorganic particles 14 is preferably 25 parts by mass or more and 60 parts by mass or less, relative to 100 parts by mass of the above-described polymerizable compound.

When silica particles are used as the inorganic particles, the silica particles may be reactive silica particles. The above-described reactive silica particles are silica particles that can form cross-linkages with the above-described polymerizable compound, and the presence of the reactive silica particles can significantly increase the hardness of the hard coat layer 12.

The above-described reactive silica particle preferably carries a reactive functional group on the surface, and a polymerizable functional group, such as those described above, is suitably used as the reactive functional group.

The above-described reactive silica particles are not limited to particular reactive silica particles, and conventionally known reactive silica particles can be used, examples of which include reactive silica particles described in JP2008-165040A. Additionally, commercially available reactive silica particles as describe above include, for example, MIBK-SD, MIBK-SD-MS, MIBK-SD-L, and MIBK-SD-ZL, which are all manufactured by Nissan Chemical Industries, Ltd., and V8802 and V8803, which are both manufactured by JGC C&C.

The hard coat layer 12 may further contain organic particles, in addition to the inorganic particles 14, for different purposes. Examples of the organic particles include poly(methyl methacrylate) particles, acrylic-styrene copolymer particles, melamine resin particles, polycarbonate particles, polystyrene particles, cross-linked polystyrene particles, polyvinyl chloride particles, benzoguanamine-melamine-formaldehyde particles, silicone particles, fluorocarbon resin particles, and polyester resin particles. The organic particles may be admixed with an inorganic component.

### <Ultraviolet Absorber>

The ultraviolet absorber has an ultraviolet absorbing function. The ultraviolet absorber is not specifically limited, and examples of the ultraviolet absorber include triazine-based ultraviolet absorbers, benzophenone-based ultraviolet absorbers, and benzotriazole-based ultraviolet absorbers.

Examples of the above-described triazine-based ultraviolet absorber include 2-(2-hydroxy-4-[1-octyloxycarbonylethoxy]phenyl)-4,6-bis(4-phenylphenyl)-1,3,5-triazine, 2-[4-[(2-hydroxy-3-dodecyloxypropyl)oxy]-2-hydroxyphenyl]-4,6-bis(2,4-dimethylphenyl)-1,3,5-triazine, 2,4-bis[2-hydroxy-4-butoxyphenyl]-6-(2,4-dibutoxyphenyl)-1,3,5-triazine, 2-[4-[(2-hydroxy-3-tridecyloxypropyl)oxy]-2-hydroxyphenyl]-4,6-bis(2,4-dimethylphenyl)-1,3,5-triazine, and 2-[4-[(2-hydroxy-3-(2'-ethyl)hexyl)oxy]-2-hydroxyphenyl]-4,6-bis(2,4-dimethylphenyl)-1,3,5-triazine. Commercially available triazine-based ultraviolet absorbers include, for example, Tinuvin 460 and Tinuvin 477 (both of them are manufactured by BASF Japan Ltd.).

### <Leveling Agent>

The leveling agent refers to an additive that prevents defects in the hard coat layer 12 caused by uneven surface tension, such as fish eyes, craters, pin holes, and orange peel, and smooths the surface. Examples of the leveling agent include, but are not specifically limited to, compounds having a polyether group(s), a polyurethane group(s), an epoxy group(s), a carboxyl group(s), an acrylate group(s), a methacrylate group(s), a carbinol group(s), or a hydroxyl group(s). The above-described leveling agent may have a polyether group(s), a polyurethane group(s), an epoxy group(s), a carboxyl group(s), an acrylate group(s), a methacrylate group(s), a carbinol group(s), or a hydroxyl group(s) at one or both ends of the main chain or in the side chain, or at one or both ends of the main chain and in the side chain. The leveling agent is not specifically limited as long as it is a compound having a polyether group, a polyurethane group, an epoxy group, a carboxyl group, an acrylate group, a methacrylate group, a carbinol group, or a hydroxyl group. Examples of the leveling agent include silicone-based leveling agents, fluorine-based leveling agents, silicone/fluorine mixture-based leveling agents, acrylic leveling agents, methacrylic leveling agents, and aromatic leveling agents.

Commercially available silicone-based leveling agents include, for example, polyester-modified silicone oil products, such as BYK-300, BYK-302, BYK-306, BYK-307, BYK-320, BYK-325, BYK-330, BYK-331, BYK-333, BYK-337, BYK-341, BYK-344, BYK-345, BYK-346, BYK-348, BYK-377, BYK-378, BYK-UV3500, BYK-3510, and BYK-UV3570 (all of them are manufactured by BYK Japan KK).

### <Silane Coupling Agent>

The silane coupling agent is an organosilicon compound having a reactive functional group and a hydrolyzable group(s). The reactive functional group is a group capable of reacting with, for example, the polyfunctional radiation-polymerizable compound, and the reactive functional group may be one or more selected from the group consisting of vinyl group, epoxy group, styryl group, (meth)acryloyl group, amino group, ureido group, thiol group, sulfide group, and isocyanate group.

The hydrolyzable group is a group capable of undergoing hydrolysis to produce a silanol group (Si-OH) and an alcohol, and examples of the hydrolyzable group include halogen atoms, alkoxy group, acyloxy group, alkenyloxy group, carbamoyl group, amino group, aminooxy group, and ketoxymate group. In cases where the hydrolyzable group is a carbon-containing hydrolyzable group, the number of carbon atoms is preferably 6 or less, and more preferably 4 or less. In particular, the hydrolyzable group is preferably an alkoxy or alkenyloxy group having 4 or less carbon atoms, and particularly preferably methoxy group or ethoxy group.

Specific examples of the silane coupling agent include [3-(methacryloyloxy)propyl]methyldimethoxysilane, [3-(methacryloyloxy)propyl]trimethoxysilane, [3-(methacryloyloxy)propyl]methyldiethoxysilane, [3-(methacryloyloxy)propyl]triethoxysilane, and [3-(acryloyloxy)propyl]triethoxysilane. Commercially available silane coupling agents include, for example, KBM-5103, KBM-502, KBM-503, KBE-502, KBE-503, and KR-513 (all of them are manufactured by Shin-Etsu Chemical Co., Ltd.).

### <<Functional Layer>>

The functional layer 16 is a layer that exerts some function in the functional film 10. The functional layer 16 is an inorganic layer. The functional layer 16 can be formed by an evaporation process, such as a sputtering technique or a CVD technique.

Examples of the functional layer 16 include, but are not specifically limited to, an adhesion-improving layer, an antireflection layer, a barrier layer, an electroconductive layer, an antiglare layer, an antistatic layer, an antifouling layer, and a combination thereof. The functional layer 16 shown in FIG. 1 is an antireflection layer. The functional layer may have a monolayer structure or a multilayer structure. Specifically, the functional layer 16 may be composed of an adhesion-improving layer 17 and an antireflection layer 18, as shown in FIG. 1, or may comprise no adhesion-improving layer 17.

The functional layer 16 preferably has a film thickness of 10 nm or more and 2 µm or less. The functional layer 16 with a film thickness of 10 nm or more can exert desired functions, while the functional layer 16 with a film thickness of 2 µm or less can inhibit the functional layer 16 from rupture due to the residual stress generated during the film formation, or from detachment due to changes in temperature and humidity. More preferably, the functional layer 16 has a minimum film thickness of 20 nm or more and a maximum film thickness of 1 µm or less. In cases where the functional layer has a multilayer structure, the film thickness of the functional layer is the sum of the film thicknesses of all the sublayers.

### <Adhesion-Improving Layer>

The adhesion-improving layer 17 preferably has a film thickness of 15 nm or less. The adhesion-improving layer 17 with a film thickness of 15 nm or less can achieve an improving effect on adhesion without adversely affecting the optical properties. The film thickness of an adhesion-improving layer is defined as the arithmetic mean of thickness values measured at randomly selected 10 locations, where the thickness is measured at the 10 locations within a cross-sectional image of the adhesion-improving layer captured using a scanning transmission electron microscope (STEM) or a transmission electron microscope (TEM) at a magnification of 10,000 to 500,000 times.

The adhesion-improving layer 17 is an inorganic layer. Specifically, the adhesion-improving layer 17 is composed of a metal nitride, such as SiNₓ, or a metal oxide, such as SiOₓ (x = 1 to 2) or CrOₓ (x = 1 to 2).

As a method of forming the adhesion-improving layer 17, for example, a physical vapor deposition (PVD) technique, such as sputtering or ion plating, or a chemical vapor deposition (CVD) technique may be used. In cases where the adhesion-improving layer 17 is composed of an inorganic material, a sputtering technique or a CVD technique is preferred as the method of forming the adhesion-improving layer.

### <Antireflection Layer>

The antireflection layer 18 is a layer that has a function to reduce reflection of external light. The antireflection layer 18 is an inorganic layer. In cases where the antireflection layer has a multilayer structure, the antireflection layer may have a layered structure consisting of a low refractive index layer, a high refractive index layer, another low refractive index layer, and another high refractive index layer.

The refractive index of a high refractive index layer is higher than the refractive index of a low refractive index layer, and the refractive index of each layer can be obtained as the average of 10 measured values of the refractive index of each layer, where 10 fragments are taken from each layer by, for example, cutting out the layer, and the refractive index of each layer is measured in each of the 10 fragments by the Becke method. In the Becke method, refractive index standard liquids with known refractive indices are used, and one of the refractive index standard liquids is dropped on the above-described fragment placed on, for example, a slide glass to immerse the fragment with the refractive index standard liquid, and the fragment immersed with the refractive index standard liquid is observed by microscopy, and the refractive index standard liquid is replaced by another to find a refractive index standard liquid that renders a bright line (Becke line) undetectable by naked eyes, which appears over the surface of each layer due to the difference in refractive index between the surface of the reinforced component and the refractive index standard liquid, and the refractive index of this refractive index standard liquid is determined as the refractive index of the layer.

The low refractive index layers preferably have a refractive index of 1.55 or less. The minimum refractive index of the low refractive index layers is more preferably 1.50 or less, further preferably 1.48 or less. The high refractive index layers may have a refractive index of 1.560 or more and 2.50 or less.

The low refractive index layers preferably have a film thickness of 20 nm or more and 500 nm or less. The high refractive index layers preferably have a film thickness of 20 nm or more and 500 nm or less. The film thicknesses of the low refractive index layers and of the high refractive index layers can be measured by the same method as that for the film thickness of the adhesion-improving layer 17.

### <Barrier Layer>

The barrier layer is a layer that has a function to block permeation of water vapor and oxygen. A material that forms the barrier layer is not limited to a particular material, provided that the material will provide a good barrier property. Examples of the material include inorganic materials, such as inorganic oxides and metals, including silicon oxide, aluminium oxide, and the like.

The film thickness of the barrier layer is not specifically limited, but is preferably 0.01 µm or more and 1 µm or less. The barrier layer with a film thickness of 0.01 µm or more can provide sufficient barrier performance, while the barrier layer with a film thickness of 1 µm or less can prevent deterioration of barrier performance due to, for example crack formation in the barrier layer. More preferably, the barrier layer has a minimum thickness of 0.03 µm or more and a maximum thickness of 0.5 µm or less.

The film thickness of the barrier layer can be measured by the same method as that for the film thickness of the adhesion-improving layer 17. Additionally, the barrier layer may be composed of a single layer or of multiple laminated layers. In cases where the barrier layer is composed of multiple laminated layers, the film thickness of the barrier layer refers to the sum of the film thicknesses of all the sublayers of the barrier layer.

As a method of forming the barrier layer, for example, a physical vapor deposition (PVD) technique, such as sputtering or ion plating, or a chemical vapor deposition (CVD) technique may be used. In cases where the barrier layer is composed of an inorganic material, a CVD technique is preferred as the method of forming the barrier layer.

### <Electroconductive Layer>

The electroconductive layer is a layer that is electroconductive. The electroconductive layer comprises, for example, an inorganic light-transmitting electroconductive material, an organic light-transmitting electroconductive material, or a composite material consisting of an inorganic light-transmitting electroconductive material and an organic light-transmitting electroconductive material. Examples of the inorganic light-transmitting electroconductive material include metal oxides, such as tin-doped indium oxide (ITO), antimony-doped tin oxide (ATO), zinc oxide, indium oxide (In₂O₃), aluminum-doped zinc oxide (AZO), gallium-doped zinc oxide (GZO), tin oxide, zinc oxide/tin oxide, indium oxide/tin oxide, and zinc oxide/indium oxide/magnesium oxide, and carbon nanotubes. Among those, tin-doped indium oxide (ITO) is preferred as the inorganic light-transmitting electroconductive material from the viewpoint of high transparency and low electrical resistance in the transparent electroconductive layer. Examples of the organic transparent electroconductive material include electroconductive polymers.

The electroconductive layer preferably has a film thickness of 15 nm or more and 50 nm or less. The film thickness of the electroconductive layer can be measured by the same method as that for the film thickness of the adhesion-improving layer 17.

A method of forming the electroconductive layer is not limited to a particular method, and a PVD technique, such as sputtering, vacuum deposition, or ion plating, a CVD technique, a coating technique, a printing technique, or the like can be used as the method. In cases where the electroconductive layer is composed of an inorganic light-transmitting electroconductive material, PVD techniques are preferred as the method of forming the electroconductive layer.

### <<Other Functional Films and Hard Coat Films>>

Although either the functional film 10 or the hard coat film 15 shown in FIG. 1 comprises a light-transmitting base material 11, other functional or hard coat films may comprise no light-transmitting base material. For example, the functional film 20 shown in FIG. 3 comprises a hard coat layer 12 containing a binder resin 13 and plural inorganic particles 14, and a functional layer 16 that is closely attached to the front surface 12A of the hard coat layer 12, and comprises no light-transmitting base material. The hard coat film in FIG. 3 is only composed of the hard coat layer 12. In FIG. 3, the elements indicated by the same reference numbers as in FIG. 1 are the same as those indicated in FIG. 1, and will not be described here.

### <<Production Method for Functional Films and Hard Coat Films>>

The functional film 10 and the hard coat film 15 can be produced as follows. First of all, a hard coat layer composition is applied on one surface of a light-transmitting base material 11 by a coating apparatus such as bar coater to form a coating film of the hard coat layer composition.

### <Hard Coat Layer Composition>

The hard coat layer composition contains a polymerizable compound and inorganic particles 14 for forming a hard coat layer 12. The hard coat layer composition may additionally contain an ultraviolet absorber, a leveling agent, a silane coupling agent, a solvent, a polymerization initiator, and organic particles, as necessary.

### (Solvent)

Examples of the above-described solvent include alcohols (for example, methanol, ethanol, propanol, isopropanol, n-butanol, s-butanol, t-butanol, benzyl alcohol, PGME, ethylene glycol, diacetone alcohol), ketones (for example, acetone, methyl ethyl ketone, methyl isobutyl ketone, cyclopentanone, cyclohexanone, heptanone, diisobutyl ketone, diethyl ketone, diacetone alcohol), esters (methyl acetate, ethyl acetate, butyl acetate, n-propyl acetate, isopropyl acetate, methyl formate, PGMEA), aliphatic hydrocarbons (for example, hexane, cyclohexane), halogenated hydrocarbons (for example, methylene chloride, chloroform, carbon tetrachloride), aromatic hydrocarbons (for example, benzene, toluene, xylene), amides (for example, dimethylformamide, dimethylacetamide, N-methylpyrrolidone), ethers (for example, diethyl ether, dioxane, tetrahydrofuran), ether alcohols (for example, 1-methoxy-2-propanol), and carbonates (dimethyl carbonate, diethyl carbonate, ethylmethyl carbonate). These solvents may be used individually or in combination of two or more. Among those solvents, methyl isobutyl ketone and methyl ethyl ketone are preferred as the above-described solvent in terms of the ability to dissolve or disperse components such as urethane (meth)acrylate and other additives, whereby the first hard coat layer composition can be suitably applied.

### (Polymerization initiator)

The polymerization initiator is a component which degrades, when exposed to ionizing radiation, and generates radicals to initiate or promote polymerization (cross-linking) of a polymerizable compound.

The polymerization initiator is not specifically limited, provided that a substance that initiates a radical polymerization can be generated by exposure to ionizing radiation. The polymerization initiator is not specifically limited, and any known polymerization initiator can be used, specifically including, for example, acetophenones, benzophenones, Michler's benzoyl benzoate, α-amyloxime esters, thioxantones, propyophenones, benzyls, benzoins, and acylphosphine oxides. Additionally, a photosensitizer is preferably mixed for use, and specific examples of the photosensitizer include n-butylamine, triethylamine, and poly-n-butylphosphine.

After the coating film of the hard coat layer composition is formed, the coating film is heated and dried at a temperature of, for example, 30°C or higher and 120°C or lower for a period of 10 seconds to 120 seconds by various known techniques to evaporate the solvent.

The coating film is dried and then cured (fully cured) by exposure to ionizing radiation such as ultraviolet light to form a hard coat layer 12.

After the hard coat layer 12 is formed, the surface of the hard coat layer 12 is etched to yield a hard coat film 15. Specifically, the binder resin 13 near the surface of the hard coat layer 12 is selectively etched. Some inorganic particles 14 may be allowed to be exposed by this process. Examples of a method of selectively etching the binder resin 13 include glow discharge treatment, plasma treatment, ion etching treatment, and alkali treatment. However, the etching process may be omitted in cases where sufficient adhesion is achieved due to the presence of an adhesion-improving layer.

After the front surface 12A of the hard coat layer 12 is etched, an adhesion-improving layer 17 and an antireflection layer 18 are formed by, for example, a vapor deposition technique such as sputtering to form a functional layer 16. This process yields a functional film 10.

Either the optically functional film 20 or the hard coat film shown in FIG. 3 can be acquired by following the same procedure as described above to form a hard coat layer 12 and a functional layer 16 on a mold release film, and removing the mold release film after the formation of the functional layer 16.

According to the present embodiment, the first region R1 includes a high-denseness layer zone in which the denseness of the inorganic particles 14 is 60% or more, so that more inorganic particles 14 are located near the front surface 12A in the hard coat layer 12. Thus, the front surface 12A of the hard coat layer 12 is specifically occupied by a larger amount of the inorganic materials. Since inorganic materials with similar compositions are generally well associated with each other, the hard coat layer 12 can well adhere to the functional layer 16, though the former layer contains the binder resin 13, in cases where the functional layer 16 is an inorganic layer. Moreover, the hard coat layer 12 can well adhere to the functional layer 16, because the former layer contains the binder resin 13, also in cases where the functional layer 16 is an organic layer. This can enhance the adhesion between the hard coat layer 12 and the functional layer 16. Additionally, deterioration in optical properties, which occurs due to the presence of too many inorganic particles 14, can be inhibited by the second region R2 in which the denseness of the inorganic particles 14 is 59% or less. Accordingly, adhesion between the hard coat layer 12 and the functional layer 16 as well as desired optical properties can be achieved.

### <<<Polarizing Plate>>>

Either the functional film 10 or the hard coat film 15 can be incorporated into, for example, a polarizing plate and then used. In the present embodiment, either the functional film 10 or the hard coat film 15 is used as a protective film for polarizers, but the intended uses of the functional film 10 and the hard coat film 15 are not specifically limited.

As shown in FIG. 4, a polarizing plate 30 comprises a functional film 10, a polarizer 31 provided on the second surface 11B of the light-transmitting base material 11, opposite to the first surface 11A facing toward the hard coat layer 12, in the functional film 10, and a protective film 32 provided on a side of the polarizer 31, opposite to the side facing toward the functional film 10. The protective film 32 may be a phase contrast film.

The polarizer 31 includes uniaxially stretched polyvinyl alcohol resin-based films stained with iodine or a dichromatic pigment. As the polyvinyl alcohol resin, a saponified polyvinyl acetate resin can be used. Examples of the polyvinyl acetate resin include polyvinyl acetates as homopolymers of vinyl acetate, and further include copolymers of vinyl acetate and another monomer copolymerizable therewith. Examples of said another monomer copolymerizable with vinyl acetate include unsaturated carboxylic acids, olefins, vinyl ethers, unsaturated sulfonic acids, and acrylamides with an ammonium group.

The polyvinyl alcohol-based resin may undergo modification. For example, aldehyde-modified polyvinyl alcohol such as polyvinyl formal and polyvinyl acetal can be used.

The above-described functional film 10, hard coat film 15, or polarizing plate 30 can be incorporated into, for example, an image display device and then used.

### <<<Image Display Device>>>

As shown in FIG. 5, an image display device 40 comprises a display panel 40 for mainly displaying images, and a backlight unit 60 provided on the back of the display panel 50. In the present embodiment, the image display device 40 comprises the backlight unit 60 because the display panel 50 is a liquid-crystal display panel, but the backlight unit 60 may be absent depending on the type of the display panel (display element).

### <<Display Panel>>

The display panel 50 has a structure in which a polarizing plate 51, a light-transmitting adhesive layer 52, a display element 53, a light-transmitting adhesive layer 54, and a polarizing plate 30 are layered in that order from the backlight unit 60 to the observer's side, as shown in FIG. 5. The display panel 50 is only required to comprise a polarizing plate 30 and may comprise, for example no polarizing plate 51.

The polarizing plate 51 comprises a protective film 55, a polarizer 56, and a protective film 57 in that order. The protective films 55 and 57 are composed of a triacetylcellulose film (TAC film) or a cycloolefin polymer film. The polarizer 56 is similar to the polarizer 21, and will not be described here.

The display element 53 is a liquid-crystal display element. However, the display element 53 is not limited to a liquid-crystal display element, and may be a display element in which, for example, an organic light-emitting diode (OLED), an inorganic light-emitting diode, and/or a semiconductor nanocrystal light-emitting diode (QLED) are/is used. As the liquid-crystal display element, a known liquid-crystal display element, in which, for example, a liquid-crystal layer, an alignment film, an electrode layer, and/or a color filter are/is sandwiched between 2 glass substrates, can be used.

### <<Backlight Unit>>

The backlight unit 60 illuminates the display panel 50 from the back of the display panel 50. Any known backlight unit can be used as the backlight unit 60, and, moreover, the backlight unit 60 may be either an edge light-type or a direct light-type backlight unit.

### EXAMPLES

Now, the present invention will be described in more detail by way of examples. However, the present invention is not limited to those examples.

The following components were combined to meet the composition requirements indicated below and thereby to obtain hard coat layer compositions.

### (Hard coat layer composition 1)

· A mixture of pentaerythritol triacrylate and pentaerythritol tetraacrylate (monomer; product name: "KAYARAD PET-30"; manufactured by Nippon Kayaku Co., Ltd.): 27.4 parts by mass;
· EO-modified isocyanurate diacrylate and triacrylate (monomer; product name: "M-313"; manufactured by Toagosei Co., Ltd.): 25.0 parts by mass;
· Poly(methyl methacrylate) (PMMA) polymer, 25% solution (in a 9:1 solution of toluene : anone; product name: "HRAG Acryl"; manufactured by DNP Fine Chemicals Co., Ltd.): 12.0 parts by weight;
· Silica particles (with a particle size of 25 nm measured by the BET method; product name: "ELECOM V8803-25"; manufactured by JGC C&C): 37.5 parts by mass;
· Polymerization initiator (1-hydroxycyclohexyl phenyl ketone; product name: "Irgacure^{®} 184"; manufactured by BASF Japan Ltd.): 6.5 parts by mass;
· Polymerization initiator (2-methyl-1-(4-methylthiophenyl)-2-morpholinopropan-1-one; product name: "Irgacure^{®} 907"; manufactured by BASF Japan Ltd.): 1.5 parts by mass;
· Toluene (solvent; product name: "Toluol"; manufactured by DIC Graphics Corporation): 108.2 parts by mass;
· Cyclohexanone (solvent; product name: "Anone"; manufactured by Yamaichi Chemical Industries Co., Ltd.): 24.5 parts by mass;
· Normal butanol: 37.0 parts by mass;
· Methyl isobutyl ketone (solvent; product name: "4-methyl-2-pentanone"; manufactured by Kanto Chemical Co., Inc.): 36.9 parts by mass.

### (Hard coat layer composition 2)

· A mixture of pentaerythritol triacrylate and pentaerythritol tetraacrylate (monomer; product name: "KAYARAD PET-30"; manufactured by Nippon Kayaku Co., Ltd.): 37.5 parts by mass;
· EO-modified isocyanurate diacrylate and triacrylate (monomer; product name: "M-313"; manufactured by Toagosei Co., Ltd.): 25.0 parts by mass;
· Poly(methyl methacrylate) (PMMA) polymer, 25% solution (in a 9:1 solution of toluene : anone; product name: "HRAG Acryl"; manufactured by DNP Fine Chemicals Co., Ltd.): 12.0 parts by weight;
· Silica particles (with a particle size of 25 nm measured by the BET method; product name: "ELECOM V8803-25"; manufactured by JGC C&C): 37.5 parts by mass;
· Organic particles (product name: "504 TNR"; manufactured by Sekisui Kasei Co., Ltd.): 2.2 parts by mass;
· Organic particles (particle size: 3.5 µm; product name: "SOLIOSTAR RA-E35FX"; manufactured by Nippon Shokubai Co., Ltd.): 9.5 parts by mass;
· Polymerization initiator (1-hydroxycyclohexyl phenyl ketone; product name: "Irgacure^{®} 184"; manufactured by BASF Japan Ltd.): 6.5 parts by mass;
· Polymerization initiator (2-methyl-1- (4-methylthiophenyl) -2-morpholinopropan-1-one (product name: "Irgacure^{®} 907"; manufactured by BASF Japan Ltd.): 1.5 parts by mass;
· Toluene (solvent; product name: "Toluol"; manufactured by DIC Graphics Corporation): 108.2 parts by mass;
· Cyclohexanone (solvent; product name: "Anone"; manufactured by Yamaichi Chemical Industries Co., Ltd.): 24.5 parts by mass;
· Normal butanol: 37.0 parts by mass;
· Methyl isobutyl ketone (solvent; product name: "4-methyl-2-pentanone"; manufactured by Kanto Chemical Co., Inc.): 36.9 parts by mass.

### (Hard coat layer composition 3)

· A mixture of pentaerythritol triacrylate and pentaerythritol tetraacrylate (monomer; product name: "KAYARAD PET-30"; manufactured by Nippon Kayaku Co., Ltd.): 48 parts by mass;
· EO-modified isocyanurate diacrylate and triacrylate (monomer; product name: "M-313"; manufactured by Toagosei Co., Ltd.): 32.0 parts by mass;
· Poly(methyl methacrylate) (PMMA) polymer, 25% solution (in a 9:1 solution of toluene : anone; product name: "HRAG Acryl"; manufactured by DNP Fine Chemicals Co., Ltd.): 12.0 parts by weight;
· Silica particles (with a particle size of 25 nm measured by the BET method; product name: "ELECOM V8803-25"; manufactured by JGC C&C): 30.0 parts by mass;
· Organic particles (product name: "504 TNR"; manufactured by Sekisui Kasei Co., Ltd.): 2.2 parts by mass;
· Organic particles (particle size: 3.5 µm; product name: "SOLIOSTAR RA-E35FX"; manufactured by Nippon Shokubai Co., Ltd.): 9.5 parts by mass;
· Polymerization initiator (1-hydroxycyclohexyl phenyl ketone; product name: "Irgacure^{®} 184"; manufactured by BASF Japan Ltd.): 6.5 parts by mass;
· Polymerization initiator (2-methyl-1- (4-methylthiophenyl) -2-morpholinopropan-1-one (product name: "Irgacure^{®} 907"; manufactured by BASF Japan Ltd.): 1.5 parts by mass;
· Toluene (solvent; product name: "Toluol"; manufactured by DIC Graphics Corporation): 108.2 parts by mass;
· Cyclohexanone (solvent; product name: "Anone"; manufactured by Yamaichi Chemical Industries Co., Ltd.): 24.5 parts by mass;
· Normal butanol: 37.0 parts by mass;
· Methyl isobutyl ketone (solvent; product name: "4-methyl-2-pentanone"; manufactured by Kanto Chemical Co., Inc.): 36.9 parts by mass.

### (Hard coat layer composition 4)

· A mixture of pentaerythritol triacrylate and pentaerythritol tetraacrylate (monomer; product name: "KAYARAD PET-30"; manufactured by Nippon Kayaku Co., Ltd.): 35.0 parts by mass;
· EO-modified isocyanurate diacrylate and triacrylate (monomer; product name: "M-313"; manufactured by Toagosei Co., Ltd.): 25.0 parts by mass;
· Poly(methyl methacrylate) (PMMA) polymer, 25% solution (in a 9:1 solution of toluene : anone; product name: "HRAG Acryl"; manufactured by DNP Fine Chemicals Co., Ltd.): 12.0 parts by weight;
· Silica particles (with a particle size of 25 nm measured by the BET method; product name: "ELECOM V8803-25"; manufactured by JGC C&C): 40.0 parts by mass;
· Organic particles (product name: "504 TNR"; manufactured by Sekisui Kasei Co., Ltd.): 2.2 parts by mass;
· Organic particles (particle size: 3.5 µm; product name: "SOLIOSTAR RA-E35FX"; manufactured by Nippon Shokubai Co., Ltd.): 9.5 parts by mass;
· Polymerization initiator (1-hydroxycyclohexyl phenyl ketone; product name: "Irgacure^{®} 184"; manufactured by BASF Japan Ltd.): 6.5 parts by mass;
· Polymerization initiator (2-methyl-1- (4-methylthiophenyl) -2-morpholinopropan-1-one (product name: "Irgacure^{®} 907"; manufactured by BASF Japan Ltd.): 1.5 parts by mass;
· Toluene (solvent; product name: "Toluol"; manufactured by DIC Graphics Corporation): 108.2 parts by mass;
· Cyclohexanone (solvent; product name: "Anone"; manufactured by Yamaichi Chemical Industries Co., Ltd.): 24.5 parts by mass;
· Normal butanol: 37.0 parts by mass;
· Methyl isobutyl ketone (solvent; product name: "4-methyl-2-pentanone"; manufactured by Kanto Chemical Co., Inc.): 36.9 parts by mass.

### (Hard coat layer composition 5)

· A mixture of pentaerythritol triacrylate and pentaerythritol tetraacrylate (monomer; product name: "KAYARAD PET-30"; manufactured by Nippon Kayaku Co., Ltd.): 37.5 parts by mass;
· EO-modified isocyanurate diacrylate and triacrylate (monomer; product name: "M-313"; manufactured by Toagosei Co., Ltd.): 25.0 parts by mass;
· Poly(methyl methacrylate) (PMMA) polymer, 25% solution (in a 9:1 solution of toluene : anone; product name: "HRAG Acryl"; manufactured by DNP Fine Chemicals Co., Ltd.): 12.0 parts by weight;
· Polymerization initiator (1-hydroxycyclohexyl phenyl ketone; product name: "Irgacure^{®} 184"; manufactured by BASF Japan Ltd.): 6.5 parts by mass;
· Polymerization initiator (2-methyl-1- (4-methylthiophenyl) -2-morpholinopropan-1-one (product name: "Irgacure^{®} 907"; manufactured by BASF Japan Ltd.): 1.5 parts by mass;
· Toluene (solvent; product name: "Toluol"; manufactured by DIC Graphics Corporation): 108.2 parts by mass;
· Cyclohexanone (solvent; product name: "Anone"; manufactured by Yamaichi Chemical Industries Co., Ltd.): 24.5 parts by mass;
· Normal butanol: 37.0 parts by mass;
· Methyl isobutyl ketone (solvent; product name: "4-methyl-2-pentanone"; manufactured by Kanto Chemical Co., Inc.): 36.9 parts by mass.

### (Hard coat layer composition 6)

· A mixture of pentaerythritol triacrylate and pentaerythritol tetraacrylate (monomer; product name: "KAYARAD PET-30"; manufactured by Nippon Kayaku Co., Ltd.): 6.9 parts by mass;
· Reactive polymer (product name: "Hitaloid 7988"; manufactured by Hitachi Chemical Co., Ltd.): 26.6 parts by mass;
· Silica particles suspension (with a particle size of 40 to 50 nm measured by the BET method; solid content: 30% by mass; dispersion medium: isopropanol (MIBK); product name: "MIBK-ST-L"; manufactured by Nissan Chemical Corporation): 25.3 parts by mass;
· Polymerization initiator (1-hydroxycyclohexyl phenyl ketone; product name: "Irgacure^{®} 184"; manufactured by BASF Japan Ltd.): 4.6 parts by mass;
· Methyl isobutyl ketone (solvent; product name: "4-methyl-2-pentanone"; manufactured by Kanto Chemical Co., Inc.): 36.9 parts by mass;
· Gamma-butyrolactone (product name: "γ-butyrolactone"; manufactured by Mitsubishi Chemical Corporation): 3.8 parts by mass.

### (Hard coat layer composition 7)

· Polyfunctional urethane acrylate (product name: "KAYARAD DPHA-40H"; manufactured by Nippon Kayaku Co., Ltd.): 186 parts by mass;
· Pentaerythritol triacrylate (product name: "A-TMM-3L"; manufactured by Shin-Nakamura Chemical Co., Ltd.): 167 parts by mass;
· Acrylate polymer (product name: "BS 371"; manufactured by Arakawa Chemical Industries, Ltd.): 246 parts by mass;
· 2-Methacryloyloxyethyl acid phosphate (product name: "LIGHT ESTER P-1M"; manufactured by Kyoeisha Chemical Co., Ltd.): 27 parts by mass;
· Silica particles suspension (with a particle size of 40 to 50 nm measured by the BET method; solid content: 30% by mass; dispersion medium: methyl isobutyl ketone (MIBK); product name: "MIBK-SD-L"; manufactured by Nissan Chemical Corporation): 889 parts by mass;
· Polymerization initiator (1-hydroxycyclohexyl phenyl ketone; product name: "Irgacure^{®} 184"; manufactured by BASF Japan Ltd.): 36 parts by mass;
· Silicone-based leveling agent (product name: "BYK-377"; manufactured by BYK Japan KK): 0.6 parts by mass;
· Triazine-based ultraviolet absorber (product name: "Tinuvin 477"; manufactured by BASF Japan Ltd.): 11 parts by mass;
· Silane coupling agent (product name: "KR-513"; manufactured by Shin-Etsu Chemical Co., Ltd.): 43 parts by mass;
· Propyleneglycol monomethylether acetate (solvent; manufactured by DNP Fine Chemicals Co., Ltd.): 370 parts by mass;
· Butyl acetate (solvent; manufactured by DNP Fine Chemicals Co., Ltd.): 75 parts by mass;
· Cyclohexanone (solvent; manufactured by DNP Fine Chemicals Co., Ltd.): 352 parts by mass.

The following components were combined to meet the composition requirements indicated below and thereby to obtain an underlayer composition.

### (Underlayer composition 1)

· Polyfunctional urethane acrylate (product name: "KAYARAD DPHA-40H"; manufactured by Nippon Kayaku Co., Ltd.): 98 parts by mass;
· Pentaerythritol triacrylate (product name: "A-TMM-3L"; manufactured by Shin-Nakamura Chemical Co., Ltd.): 88 parts by mass;
· Acrylate polymer (product name: "BS 371"; manufactured by Arakawa Chemical Industries, Ltd.): 129 parts by mass;
· 2-Hydroxyethyl methacrylate (product name: "2-Hydroxyethyl Methacrylate"; manufactured by Tokyo Chemical Industry Co., Ltd.): 270 parts by mass;
· Polymerization initiator (1-hydroxycyclohexyl phenyl ketone; product name: "Irgacure^{®} 184"; manufactured by BASF Japan Ltd.): 36 parts by mass;
· Silicone-based leveling agent (product name: "BYK-377"; manufactured by BYK Japan KK): 0.6 parts by mass;
· Triazine-based ultraviolet absorber (product name: "Tinuvin 477"; manufactured by BASF Japan Ltd.): 11 parts by mass;
· Silane coupling agent (product name: "KR-513"; manufactured by Shin-Etsu Chemical Co., Ltd.): 43 parts by mass;
· Propyleneglycol monomethylether acetate (solvent; manufactured by DNP Fine Chemicals Co., Ltd.): 300 parts by mass;
· Butyl acetate (solvent; manufactured by DNP Fine Chemicals Co., Ltd.): 102 parts by mass;
· Cyclohexanone (solvent; manufactured by DNP Fine Chemicals Co., Ltd.): 285 parts by mass;
· Gamma-butyrolactone (solvent; manufactured by Mitsubishi Chemical Corporation): 151 parts by mass.

### <Example 1>

First of all, a cellulose triacetate film (product name: "TD80UL"; manufactured by Fujifilm Corporation) with a thickness of 80 µm was set up as a light-transmitting base material, and the hard coat layer composition 1 was applied on one surface of the cellulose triacetate film to form a coating film. Then, dry air at 70°C was blown over the formed coating film for 60 seconds to dry the coating film and to evaporate the solvent in the coating film, and the resulting coating film was cured by exposure to ultraviolet light to a cumulative light dose of 100 mJ/cm² to form a hard coat layer with a film thickness of 5 µm.

After the hard coat layer was formed, the surface of the hard coat layer was treated with glow discharge plasma at an intensity of 80 W·min/m², and a hard coat film was thereby obtained.

From a cross-sectional image of the hard coat layer acquired with a scanning transmission electron microscope (STEM), silica particles in the hard coat layer were confirmed to have a spherical shape, and the average primary particle size of the silica particles in the hard coat layer was measured to be 25 nm. The average primary particle size of the silica particles was defined as the arithmetic mean of the particle sizes of 20 silica particles, where the particle sizes of the 20 silica particles were measured from cross-sectional images of silica particles acquired using a scanning transmission electron microscope (STEM) at a magnification of 40,000 to 200,000 times. Additionally, the film thickness of the hard coat layer was defined as the arithmetic mean of film thickness values at 20 different locations, where a cross-section of the hard coat layer was imaged using a scanning transmission electron microscope (STEM) and the film thickness of the hard coat layer was measured at the 20 locations within the image of the cross-sectional.

Cross-sectional images of the hard coat layer were acquired using a scanning transmission electron microscope (STEM) as follows. First of all, a cut piece of the hard coat film with a size of 15 mm × 10 mm was fixed on a resin plate, and was sliced with a Ultramicrotome EM UC6 (manufactured by Leica Microsystems GmbH) to leave a portion of the film with a trimming width of 300 µm and a height of 80 µm, and the remaining portion of the film was further sliced in the thickness direction with a DiATOME diamond knife ULTRA to produce homogeneous sections having a thickness of 80 nm and having no openings or the like. Then, these homogeneous sections having no openings or the like were used as measurement samples. Subsequently, the cross-sectional images of the measurement sample were acquired using a scanning transmission electron microscope (STEM) (product name: "S-4800"; manufactured by Hitachi High-Technologies Corporation). The cross-sectional images were acquired using the above-described S-4800 by setting the detector to "TE," the accelerating voltage to "30 kV," and the emission current to "10 µA." The focus, contrast, and brightness were appropriately adjusted at a magnification of 40,000 to 100,000 times, so that each layer can be identified by observation. Furthermore, the beam monitor aperture, the objective lens aperture, and the WD were respectively set to "3," "3," and "8 mm," in acquisition of the cross-sectional images using the above-described S-4800. Also in other Examples and Comparative Examples, the shape and average primary particle size of silica particles, and the film thickness of either a hard coat layer or a functional layer were determined by the same methods as those in Example 1.

### <Example 2>

In Example 2, a hard coat film was obtained in the same manner as in Example 1, except that the hard coat layer composition 2 was used instead of the hard coat layer composition 1.

### <Example 3>

In Example 3, a hard coat film was obtained in the same manner as in Example 1, except that the hard coat layer composition 3 was used instead of the hard coat layer composition 1.

### <Example 4>

In Example 4, a hard coat film was obtained in the same manner as in Example 1, except that the hard coat layer composition 4 was used instead of the hard coat layer composition 1.

### <Example 5>

In Example 5, a hard coat film was obtained in the same manner as in Example 1, except that the drying temperature was set at 50°C.

### <Example 6>

First of all, an adhesion-improving layer having a film thickness of 5 nm and composed of SiOₓ (x = 1 to less than 2) was formed by sputtering on the front surface of the hard coat film obtained in Example 1 (the front surface of the hard coat layer). An antireflection layer was further formed by sputtering on the surface of the adhesion-improving layer to form a functional layer consisting of an adhesion-improving layer and an antireflection layer, and a functional film was thereby obtained. The antireflection layer had a multilayer structure, comprising a high refractive index layer composed of Nb₂O₅ and having a film thickness of 20 nm, a low refractive index layer composed of SiO₂ and having a film thickness of 35 nm, another high refractive index layer composed of Nb₂O₅ and having a film thickness of 35 nm, and another low refractive index layer composed of SiO₂ and having a film thickness of 100 nm, layered in that order from the bottom to the top. The refractive index was measured in the high and low refractive index layers by the Becke method, which demonstrated that the refractive index of the high refractive index layers was 2.3 and the refractive index of the low refractive index layers was 1.48.

### <Example 7>

In Example 7, a functional layer consisting of an adhesion-improving layer and an antireflection layer was formed on the front surface of the hard coat film obtained in Example 2 to obtain a functional film, by following the same procedure as that in Example 6.

### <Example 8>

In Example 8, a functional layer consisting of an adhesion-improving layer and an antireflection layer was formed on the front surface of the hard coat film obtained in Example 3 to obtain a functional film, by following the same procedure as that in Example 6.

<Example 9>

In Example 9, a functional layer consisting of an adhesion-improving layer and an antireflection layer was formed on the front surface of the hard coat film obtained in Example 4 to obtain a functional film, by following the same procedure as that in Example 6.

### <Example 10>

In Example 10, a functional layer consisting of an adhesion-improving layer and an antireflection layer was formed on the front surface of the hard coat film obtained in Example 5 to obtain a functional film, by following the same procedure as that in Example 6.

### <Comparative Example 1>

In Comparative Example 1, a hard coat film was obtained in the same manner as in Example 1, except that the hard coat layer composition 5 was used instead of the hard coat layer composition 1.

### <Comparative Example 2>

In Comparative Example 2, a hard coat film was obtained in the same manner as in Example 1, except that the hard coat layer composition 6 was used instead of the hard coat layer composition 1 and an acrylic resin film with a thickness of 40 µm was used instead of the cellulose triacetate film.

### <Comparative Example 3>

First of all, an acrylic resin film with a thickness of 40 µm was set up as a base material, and the underlayer composition 1 was applied on one surface of the acrylic resin film to form a coating film. Then, dry air at 70°C was blown over the formed coating film for 60 seconds to dry the coating film and to evaporate the solvent in the coating film, and the resulting coating film was cured by exposure to ultraviolet light to a cumulative light dose of 100 mJ/cm² to form a underlayer with a film thickness of 4 µm.

After the underlayer was formed, the hard coat layer composition 7 was applied on the surface of the underlayer to form a coating film. Then, dry air at 70°C was blown over the formed coating film for 60 seconds to dry the coating film and to evaporate the solvent in the coating film, and the resulting coating film was cured by exposure to ultraviolet light to a cumulative light dose of 100 mJ/cm² to form a hard coat layer with a film thickness of 5 µm.

### <Comparative Example 4>

In Comparative Example 4, a functional layer consisting of an adhesion-improving layer and an antireflection layer was formed on the front surface of the hard coat film obtained in Comparative Example 1 to obtain a functional film, by following the same procedure as that in Example 6.

### <Comparative Example 5>

In Comparative Example 5, a functional layer consisting of an adhesion-improving layer and an antireflection layer was formed on the front surface of the hard coat film obtained in Comparative Example 2 to obtain a functional film, by following the same procedure as that in Example 6.

### <Comparative Example 6>

In Comparative Example 6, a functional layer consisting of an adhesion-improving layer and an antireflection layer was formed on the front surface of the hard coat film obtained in Comparative Example 3 to obtain a functional film, by following the same procedure as that in Example 6.

### <Denseness of Silica Particles>

In each of the hard coat films and functional films according to Examples and Comparative Examples, the denseness of silica particles was measured in both a first region ranging from the front surface to a depth of 100 nm in the hard coat layer and a second region below a depth of 100 nm from the front surface in the hard coat layer. Specifically, the denseness of silica particles in the first region was determined by the following method. First of all, a cross-sectional image of the hard coat layer captured using scanning transmission electron microscope (STEM) (product name: "S-4800"; manufactured by Hitachi High-Technologies Corporation) at a magnification of 30,000 to 100,000 times (see FIG. 6) was acquired and processed by an image processing software program (product name: "ImageJ"; created by the National Institute of Health, United States) to binarize each cell in the image into black/white. In this respect, the size of the binarized image was 640 x 480 pixels or more. In the cross-sectional image captured by the STEM, the silica particles with a higher density were shown in black color because a less intense electron beam was transmitted through the silica particles, and the binder resin, whose density was lower than that of the silica particles, was shown in white color. Thus, after the binarization, the silica particles were expressed as black regions, and the binder resin was expressed as white regions. Cells with values closer to values corresponding to white and black colors were classified as representing the area occupied by the resin and the area occupied by the particles, respectively, where the average value of all the cells was set as a threshold for the classification. In cells appearing in the binarized image, each cell on a row was classified as belonging to a black or white region, where a row comprised plural cells arranged in the direction orthogonal to the film thickness direction of the hard coat layer, to determine the percentage of cells determined as belonging to black regions in the total number of cells on the row. The entire first region was analyzed to determine the maximum denseness of silica particles. The denseness of the inorganic particles in the second region was also determined in the same manner as for the denseness of the inorganic particles in the first region, except that the denseness of the inorganic particles in the second region was determined by obtaining the above-described percentage for five rows at different depths in the second region and calculating the arithmetic mean of the obtained percentages.

Cross-sectional images of each hard coat layer were acquired with a STEM by the following method. First of all, a cut piece of each hard coat or functional film with a size of 15 mm x 10 mm was fixed on a resin plate, and was sliced with a Ultramicrotome EM UC6 (manufactured by Leica Microsystems GmbH) to leave a portion of the film with a trimming width of 300 µm and a height of 80 µm, and the remaining portion of the film was further sliced in the thickness direction with a DiATOME diamond knife ULTRA to produce homogeneous sections having a thickness of 80 nm and having no openings or the like. Subsequently, cross-sectional images of the measurement sample were acquired using a STEM (product name: "S-4800"; manufactured by Hitachi High-Technologies Corporation). The cross-sectional images were acquired using the above-described S-4800 by setting the detector to "TE," the accelerating voltage to "30 kV," and the emission current to "10 µA." The focus, contrast, and brightness were appropriately adjusted at a magnification of 40,000 to 150,000 times, so that each layer can be identified by observation. Moreover, the beam monitor aperture, the objective lens aperture, and the WD were respectively set to "3," "3," and "8 mm," in acquisition of cross-sectional images using the above-described S-4800.

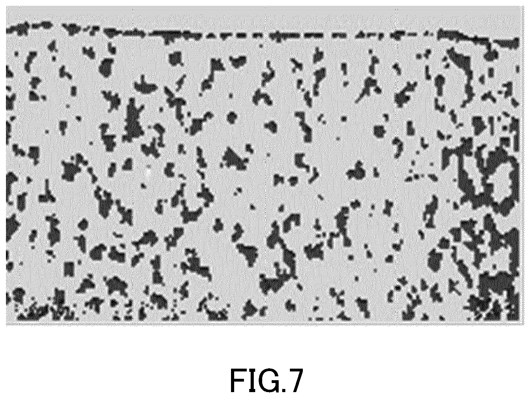

The above-described binarization was performed with an image processing software program (product name: "ImageJ"; created by the National Institute of Health, United States), and was specifically performed by the following procedure. First of all, a cross-sectional image was acquired by the above-described software program, to add a specific value representing a black-and-white gradation of each pixel in the image to a cell in a spreadsheet, where one pixel corresponded to one cell (see FIG. 7). The number of gradations was 255. FIG. 6 shows a scanning transmission electron micrograph showing a cross-section of the hard coat layer in the functional film according to Example 1, and FIG. 7 shows a binarized image of the hard coat film according to Example 1 processed with spreadsheet software.

### <Maximum Aggregation Degree of Silica Particles in the Second Region>

In each of the hard coat films and functional films according to Examples and Comparative Examples, the maximum aggregation degree of silica particles in the second region was measured. Specifically, images were first binarized into black and white images by the same method and the same conditions as those for the above-described measurement of the denseness of silica particles. In cells appearing in a binarized image, the ratio of a series of cells connected to each other in a length of three or more times the primary particle size of the silica particle to the total number of cells in a row was then determined to calculate the aggregation degree of silica particles for the row, where a row comprised plural cells arranged in the direction perpendicular to the film thickness direction of the hard coat layer, and a series of cells connected to each other in a length of three or more times the primary particle size of the silica particle was considered as an aggregate of cells. Then, the aggregation degree of silica particles was determined for 30 rows, and the largest aggregation degree among the aggregation degrees of silica particles determined for the 30 rows was defined as the maximum aggregation degree.

### <Adhesion Property>

In each of the hard coat films and functional films according to Examples and Comparative Examples, the adhesion was evaluated by the cross-cut test. In each hard coat film, an adhesion-improving layer and an antireflection layer were formed on the front surface of the hard coat film (the front surface of the hard coat layer) by the same method as that in Example 6 to evaluate the adhesion. In each functional film, the functional film was directly subjected to the evaluation of adhesion. Specifically, a Cross-Cut CCJ-1 (manufactured by COTEC Corporation) was used in accordance with JIS K5600-5-6: 1999 to engrave a grid of 100 squares (each 1 mm x 1 mm) on the front surface of either a hard coat film or a functional film with an antireflection layer formed on a hard coat layer. Then, a Cello Tape^{®} with a width of 24 mm for industrial use, manufactured by Nichiban Co., Ltd., was placed over the grid, rubbed 10 times in a reciprocating motion with a spatula to make adhesion with the grid, and then quickly pulled in the direction at an angle of 150 degrees. This action was repeated 5 times, and the number of square films remaining to be removed was counted. The number of the remaining square films and the total number of the square films were used as the numerator and the denominator, respectively, for evaluation based on the following criteria.
⊚: 100/100
○: 91 or more/100 to 99 or less/100
△: 50 or more/100 to 90 or less/100
×: less than 50/100

### <Haze Value>

The haze value was measured in each of the hard coat films according to Examples 1 to 5 and Comparative Examples 1 and 2. The haze value was measured using a haze meter (product name: "HM-150"; manufactured by Murakami Color Research Laboratory Co., Ltd.) by a method in accordance with JIS K7136: 2000. The above-described haze value was defined as the arithmetic mean of three measurements obtained by setting a cut piece of a functional film with a size of 50 mm x 50 mm without generating any curl or wrinkle and without leaving any dirt such as fingerprints or grim in a manner that allows the antireflection layer to face in the direction opposite to the light source, measuring the haze value, and repeating the measurement three times on one functional film. The hard coat films according to Example 1 and Comparative Examples 1 to 3 are designed as films that exhibit no antiglare properties, and lower haze values are more preferable in those films. In contrast, the hard coat films according to Examples 2 to 5 are designed as films that exhibit antiglare properties, and those films preferably have a haze value of 6% or more 20% or less and a 60 degree gloss value of 70% or more and 110% or less. The 60 degree gloss value is described below.

### <Total Light Transmittance>

The total light transmittance was measured in each of the hard coat films according to Examples 1 to 5 and Comparative Examples 1 and 2. The total light transmittance was measured using a haze meter (product name: "HM-150"; manufactured by Murakami Color Research Laboratory Co., Ltd.) by a method in accordance with JIS K7361-1: 1997. The above-described total light transmittance was defined as the arithmetic mean of three measurements obtained by setting a cut piece of a functional film with a size of 50 mm x 50 mm without generating any curl or wrinkle and without leaving any dirt such as fingerprints or grim in a manner that allows the antireflection layer to face in the direction opposite to the light source, measuring the total light transmittance, and then repeating the measurement three times on one functional film. Higher values of total light transmittance are more preferable in those films.

### <60 Degree Gloss Value>

The 60 degree gloss value of each of the hard coat films according to Examples 1 to 5 and Comparative Example 1 was measured. The above-described 60 degree gloss value was measured using a precision gloss meter (product name: "GM-26D"; manufactured by Murakami Color Research Laboratory Co., Ltd.) by a method in accordance with JIS Z8741: 1997. The above-described 60 degree gloss value was measured by cutting out a piece with a size of 50 mm x 50 mm from a functional film and then placing the piece of the functional film in the precision gloss meter for the measurement, while keeping the back surface of the hard coat film closely attached to a resin plate in lusterless black color by vacuuming the air. Additionally, each 60 degree gloss value was defined as the arithmetic mean of three measurements obtained by repeating the measurement three times on one hard coat film.

### <Element ratios in Hard Coat Layer>

Each of the hard coat films according to Example 2 and Comparative Example 2 was etched in the depth direction of the hard coat layer, and the element ratios of C, N, O, and Si elements were individually determined at different depths from the front surface. Specifically, the etched hard coat layer was analyzed every 5 nm in a region ranging from the front surface to a depth of 100 nm by using a scanning X-ray photoelectron spectrometer (product name: "Quantum 2000"; manufactured by ULVAC-PHI Inc.) under the following measurement conditions to determine the element ratios of C, N, O, and Si elements.

### (Measurement conditions)

· X-ray conditions: Al, mono, diameter of 200 µm x 30W, 15kV
· Photoelectron detector angle: 45°
· Etching conditions: 2kV, raster of 2 x 2

The results in the hard coat films and in the functional films are presented in Tables 1 and 2 below, respectively. Moreover, the element ratios of C, N, O, and Si elements in the hard coat layers according to Example 2 and Comparative Example 2 are shown in Table 3.

**Table 1**

| | Average primary particle size of silica particles (nm) | Denseness of silica particles (%) | | Maximum aggregation degree of silica particles in a second region (%) | Adhesion property | Haze value (%) | Total light transmittance (%) | 60 degree gloss value (%) |
|---|---|---|---|---|---|---|---|---|
| | | First region | Second region | | | | | |
| Example 1 | 25 | 82 | 37 | 12 | ⊚ | 0.2 | 92.0 | 154.5 |
| Example 2 | 25 | 83 | 35 | 12 | ⊚ | 13.3 | 91.5 | 98.6 |
| Example 3 | 25 | 82 | 29 | 10 | ⊚ | 12.1 | 91.7 | 102.9 |
| Example 4 | 25 | 86 | 36 | 13 | ⊚ | 14.0 | 94.6 | 93.8 |
| Example 5 | 25 | 80 | 36 | 12 | ⊚ | 12.2 | 91.7 | 99.0 |
| Comparative Example 1 | - | 0 | 0 | 0 | x | 0.2 | 92.1 | 100.7 |
| Comparative Example 2 | 40-50 | 39 | 40 | 10 | Δ | 0.3 | 91.0 | - |
| Comparative Example 13 | 40-50 | 79 | 52 | 33 | ⊚ | 3.2 | 90.4 | - |

**Table 2**

| | Average primary particle size of silica particles (nm) | Denseness of silica particles (%) | | Maximum aggregation degree of silica particles in a second region (%) | Adhesion property |
|---|---|---|---|---|---|
| | | First region | Second region | | |
| Example 6 | 25 | 80 | 39 | 15 | ⊚ |
| Example 7 | 25 | 83 | 35 | 12 | ⊚ |
| Example 8 | 25 | 82 | 29 | 10 | ⊚ |
| Example 9 | 25 | 86 | 36 | 13 | ⊚ |
| Example 10 | 25 | 80 | 36 | 12 | ⊚ |
| Comparative Example 4 | - | 0 | 0 | 0 | × |
| Comparative Example 5 | 40-50 | 40 | 42 | 12 | Δ |
| Comparative Example 6 | 40-50 | 76 | 53 | 31 | ⊚ |

**Table 3**

| | | Example 2 | | | | Comparative Example 2 | | | |
|---|---|---|---|---|---|---|---|---|---|
| | | Element ratio of C | Element ratio of N | Element ratio of O | Element ratio of Si | Element ratio of C | Element ratio of N | Element ratio of O | Element ratio of Si |
| Depth (nm) | 0 | 44.0 | 1.8 | 40.7 | 13.5 | 61.1 | 2.8 | 31.7 | 4.4 |
| | 5 | 41.3 | 2.2 | 41.5 | 14.9 | 61.2 | 2.8 | 30.1 | 5.9 |
| | 10 | 16.5 | 0.6 | 54.5 | 28.4 | 83.8 | 1.8 | 9.42 | 5.0 |
| | 15 | 15.8 | 1.5 | 55.0 | 27.6 | 81.8 | 2.2 | 10.9 | 5.0 |
| | 20 | 18.1 | 1.5 | 53.8 | 26.6 | 81.2 | 1.2 | 11.9 | 5.8 |
| | 25 | 25.7 | 1.8 | 48.1 | 24.4 | 78.2 | 1.9 | 13.7 | 6.3 |
| | 30 | 33.7 | 2.0 | 42.7 | 21.7 | 76.9 | 1.8 | 14.3 | 7.0 |
| | 35 | 43.6 | 2.6 | 35.4 | 18.5 | 76.2 | 1.7 | 15.2 | 7.0 |
| | 40 | 56.2 | 2.9 | 26.3 | 14.6 | 75.1 | 1.6 | 15.7 | 7.6 |
| | 45 | 65.4 | 2.2 | 20.4 | 12.0 | 73.5 | 1.8 | 17.1 | 7.7 |
| | 50 | 70.1 | 3.0 | 17.0 | 9.9 | 72.7 | 1.6 | 17.2 | 8.5 |
| | 55 | 73.0 | 2.8 | 15.0 | 9.2 | 71.9 | 1.7 | 17.7 | 8.7 |
| | 60 | 73.7 | 2.1 | 15.2 | 9.0 | 70.7 | 1.9 | 18.7 | 8.7 |
| | 65 | 72.2 | 2.5 | 16.4 | 8.9 | 69.9 | 1.8 | 18.8 | 9.4 |
| | 70 | 68.5 | 3.1 | 17.9 | 10.6 | 67.7 | 1.8 | 20.3 | 10.2 |
| | 75 | 67.3 | 2.3 | 19.1 | 11.2 | 68.1 | 1.7 | 20.4 | 9.8 |
| | 80 | 65.3 | 3.1 | 19.7 | 11.9 | 65.4 | 2.4 | 21.9 | 10;4 |
| | 85 | 64.7 | 2.0 | 20.8 | 12.6 | 66.2 | 1.3 | 21.6 | 11.0 |
| | 90 | 65.9 | 3.0 | 19.2 | 11.9 | 64.9 | 1.5 | 22.6 | 11.0 |
| | 95 | 66.2 | 3.3 | 18.7 | 11.9 | 64.0 | 1.4 | 23.4 | 11.3 |
| | 100 | 66.0 | 3.3 | 18.6 | 12.1 | 63.9 | 1.6 | 23.2 | 11.3 |

As shown in Table 1, the hard coat films according to Comparative Examples 1 and 2 showed poor adhesion. This is considered to be because each hard coat layer has a first region without a zone in which the denseness of silica particles is 60% or more, and also has a second region with more silica particles. Additionally, the hard coat film according to Comparative Example 3 showed excellent adhesion but had a high haze value. In contrast, the hard coat film according to Example 1, which has a hard coat layer including a first region with a zone in which the denseness of silica particles is 60% or more, and also including a second region with fewer silica particles, showed excellent adhesion and high total light transmittance and had a low haze value. FIG. 6 shows a scanning transmission electron micrograph showing a cross-section of the hard coat layer in the hard coat film according to Example 1, and this micrograph also assists in understanding that more silica particles are located in the front surface of the hard coat layer than in other regions. In addition, the hard coat films according to Examples 2 to 5, each of which has a hard coat layer including a first region with a zone in which the denseness of silica particles is 60% or more and also including a second region with fewer silica particles, also showed excellent adhesion and high total light transmittance and had haze and 60 degree gloss values within the desired ranges.

Moreover, as shown in Table 2, the functional films according to Comparative Examples 4 and 5 showed poor adhesion. This is considered to be because each hard coat layer has a first region without a zone in which the denseness of silica particles is 60% or more, and also has a second region with more silica particles. The functional film according to Comparative Example 6 showed excellent adhesion, but is believed to have a high haze value, similarly to the hard coat film according to Comparative Example 3, because the hard coat film according to Comparative Example 3 is used in this functional film. In contrast, the functional film according to Example 6, which has a hard coat layer including a first region with a zone in which the denseness of silica particles is 60% or more and also including a second region with fewer silica particles, showed excellent adhesion. The functional film according to Example 6 is believed to show high total light transmittance and to have a high haze value, similarly to the hard coat film according to Example 1, because the hard coat film according to Example 1 is used in this functional film. Additionally, the functional film according to Examples 7 to 10, each of which has a hard coat layer including a first region with a zone in which the denseness of silica particles is 60% or more and also including a second region with fewer silica particles, also showed excellent adhesion. The functional film according to Examples 7 to 10 are believed to show high total light transmittance and to have haze and 60 degree gloss values within the desired ranges, similarly to the hard coat films according to Examples 2 to 5, because the hard coat films according to Examples 2 to 5 are respectively used in these functional films.

Furthermore, as shown in Table 3, the hard coat film according to Example 2 included a zone, in which the sum of the element ratios of Si and O elements was 60% or more, from a depth of 10 nm to 30 nm below the front surface of the hard coat layer, and the other zone in which the sum of the element ratios of Si and O elements was less than 60%. This is considered to be because silica particles are concentrated in the zone ranging from a depth of 10 nm to 30 nm and are homogeneously dispersed in the other zone. Thus, the hard coat layer of the hard coat film according to Example 2 was confirmed to have a first layer zone in which the sum of the element ratios of Si and O elements was 60% or more and to have a second layer zone in which the sum of the element ratios of Si and O elements was less than 60%, which were included in a first region ranging from the front surface to a depth of 100 nm in the hard coat layer. In contrast, the hard coat film according to Comparative Example 2 included a zone ranging from the front surface to a depth of 100 nm in the hard coat layer, in which the sum of the element ratios of Si and O elements was less than 60%. Thus, the hard coat layer in the hard coat film according to Comparative Example 2 was confirmed not to have a first region with a first layer zone in which the sum of the element ratios of Si and O elements was 60% or more.

In the hard coat films according to Examples 1 to 5 and the functional films according to Examples 6 to 10, the Martens hardness of each hard coat layer was measured under the measurement conditions described in the above section of Hard Coat Layer, and found to be 100 MPa or more.

### LIST OF REFERENCE NUMERALS

- 10, 20: Functional film
- 11: Light-transmitting base material
- 12: Hard coat layer
- 13: Binder resin
- 14: Inorganic particles
- 15: Hard coat film
- 16: Functional layer
- 30: Polarizing plate
- 31: Polarizer
- 40: Image display device
- 50: Display panel

## Claims

1. A functional film (10, 20) comprising a hard coat layer (12) containing a binder resin (13) and plural inorganic particles (14), which are silica particles, and a functional layer (16) closely attached to the front surface (12A) of the hard coat layer (12),
**characterized in that**
the functional layer (16) is an inorganic layer and the hard coat layer (12) comprises a first region (R1) that includes layer zones including a first layer zone, in which the sum of the element ratios of Si and O elements is 60% or more, and a second layer zone, in which the sum of the element ratios of Si and O elements is less than 60%, and a layer zone, in which the denseness of the inorganic particles (14) is 60% or more, from the front surface to a depth of 100 nm in the hard coat layer (12), and a second region (R2), in which the maximum aggregation degree of the inorganic particles (14) is 30% or less, and the denseness of the inorganic particles (14) is 59% or less, below a depth of 100 nm from the front surface (12A) in the hard coat layer (12),
wherein the maximum aggregation degree of the inorganic particles 14 in the second region R2 is determined as follows: in cells appearing in a binarized image, the ratio of a series of cells connected to each other in a length of three or more times the primary particle size of the inorganic particle to the total number of cells in a row is first determined to calculate the aggregation degree for the row, where a row comprises plural cells arranged in the direction orthogonal to the film thickness direction of the hard coat layer, and a series of cells connected to each other in a length of three or more times the primary particle size of the inorganic particle is considered as an aggregate of cells; then, the aggregation degree of inorganic particles is determined for multiple rows, and the largest aggregation degree among the aggregation degrees of inorganic particles determined for the multiple rows is defined as the maximum aggregation degree, wherein the above-described "primary particle size" refers to the smallest length among the diameters, widths, depths, and heights of the inorganic particles; and
wherein the denseness of the inorganic particles in the first region is determined by the following method: first of all, a cross-sectional image of the hard coat layer captured using a transmission electron microscope (TEM) or a scanning transmission electron microscope (STEM) at a magnification of 30,000 to 100,000 times is acquired and processed by an image processing software program to binarize each cell in the image into black/white, wherein the inorganic particles with a higher density are shown in black color and the binder resin is shown in white color; then, after the binarization, the inorganic particles are expressed as black regions, and the binder resin is expressed as white regions; wherein in cells appearing in the binarized image, each cell on a row is classified as belonging to a black or white region, where a row comprises plural cells arranged in the direction orthogonal to the film thickness direction of the hard coat layer, to determine the percentage of cells determined as belonging to black regions in the total number of cells on the row, and wherein the denseness of the inorganic particles in the second region is determined in the same manner as for the denseness of the inorganic particles in the first region, except that the denseness of the inorganic particles in the second region is determined by obtaining the above-described percentage for at least five rows at different depths in the second region and calculating the arithmetic mean of the obtained percentages.

2. The functional film (10, 20) according to claim 1, wherein at least a portion of the inorganic particles (14) are located in the interface between the hard coat layer (12) and the functional layer (16), and are closely attached to the functional layer (16).

3. The functional film (10, 20) according to claim 1 or 2, wherein the hard coat layer (12) comprises the first region (R1) that includes a layer zone, in which the denseness of the inorganic particles (14) is 70% or more, and the second region (R2), in which the denseness of the inorganic particles (14) is 50% or less.

4. The functional film (10, 20) according to claim 1, 2 or 3, wherein the film thickness of the hard coat layer (12) is 1 µm or more.

5. The functional film (10, 20) according to claim 1, 2, 3 or 4, further comprising a light-transmitting base material (11) provided on the other side of the hard coat layer (12), opposite to the side where the functional layer (16) is provided.

6. A polarizing plate (30) comprising:
the functional film (10, 20) according to claim 1, 2, 3 or 4; and
a polarizer (31) provided on the other side of the hard coat layer (12) in the functional film (10, 20), opposite to the side where the functional layer (16) is provided.

7. A polarizing plate (30) according to claim 6, comprising:
a hard coat film (15) which includes the hard coat layer (12).

8. An image display device (40) comprising the functional film (10, 20) according to claim 1 or the polarizing plate (30) according to claim 6 or 7.

9. A use of a hard coat film (15) comprising at least a hard coat layer (12) containing a binder resin (13) and plural inorganic particles (14), which are silica particles, for forming an inorganic functional layer (16) on the front surface (12A) of the hard coat layer (12), which constitutes the front surface (15A) of the hard coat film (15),
**characterized in that** the hard coat layer (12) has a first region (R1) that includes layer zones including a first layer zone, in which the sum of the element ratios of Si and O elements is 60% or more, and a second layer zone, in which the sum of the element ratios of Si and O elements is less than 60%, and a zone, in which the denseness of the inorganic particles (14) is 60% or more, from the front surface to a depth of 100 nm in the hard coat layer, and a second region (R2), in which the maximum aggregation degree of the inorganic particles (14) in the second region is 30% or less, and the denseness of the inorganic particles (14) is 59% or less, below a depth of 100 nm from the front surface (12A) in the hard coat layer (12),
wherein the denseness of the inorganic particles (14) in the first and second regions and the maximum aggregation degree of the inorganic particles (14) in the second region are determined as specified in claim 1.

10. The use of a hard coat film (15) according to claim 9, wherein the hard coat layer (12) has the first region that includes a zone, in which the denseness of the inorganic particles is 70% or more, and the second region, in which the denseness of the inorganic particles is 50% or less.

11. The use of a hard coat film (15) according to claim 9 or 10, wherein the film thickness of the hard coat layer (12) is 1 µm or more.

12. The use of a hard coat film (15) according to claim 9, 10 or 11, wherein the hard coat film (15) further comprises a light-transmitting base material (11) provided on the back surface opposite to the front surface of the hard coat layer (12).

## Patentansprüche

1. Funktioneller Film (10, 20), umfassend eine harte Überzugsschicht (12), die ein Bindemittelharz (13) und mehrere anorganische Teilchen (14) enthält, die Siliciumdioxidteilchen sind, und eine funktionelle Schicht (16), die eng an der vorderen Oberfläche (12A) der harten Überzugsschicht (12) angebracht ist,
**dadurch gekennzeichnet, dass**
die funktionelle Schicht (16) eine anorganische Schicht ist und die harte Überzugsschicht (12) einen ersten Bereich (R1) umfasst, der Schichtzonen beinhaltet, die eine erste Schichtzone, in der die Summe der Elementverhältnisse von Si- und O-Elementen 60 % oder mehr ist, und eine zweite Schichtzone, in der die Summe der Elementverhältnisse von Si- und O-Elementen weniger als 60 % ist, beinhalten, und eine Schichtzone, in der die Dichte der anorganischen Teilchen (14) 60 % oder mehr ist, von der vorderen Oberfläche bis zu einer Tiefe von 100 nm in der harten Überzugsschicht (12), und einen zweiten Bereich (R2), in dem der maximale Aggregationsgrad der anorganischen Teilchen (14) 30 % oder weniger ist und die Dichte der anorganischen Teilchen (14) 59 % oder weniger ist, unterhalb einer Tiefe von 100 nm von der vorderen Oberfläche (12A) in der harten Überzugsschicht (12),
wobei der maximale Aggregationsgrad der anorganischen Teilchen 14 in dem zweiten Bereich R2 wie folgt bestimmt wird: bei Zellen, die in einem binarisierten Bild erscheinen, wird zunächst das Verhältnis einer Reihe von Zellen, die in einer Länge von mindestens dem Dreifachen der Primärteilchengröße des anorganischen Teilchens miteinander verbunden sind, zu der Gesamtzahl der Zellen in einer Reihe bestimmt, um den Aggregationsgrad für die Reihe zu berechnen, wobei eine Reihe mehrere Zellen umfasst, die in der Richtung orthogonal zu der Richtung der Filmstärke der harten Überzugsschicht angeordnet sind, und eine Reihe von Zellen, die über eine Länge von mindestens dem Dreifachen der Primärteilchengröße des anorganischen Teilchens miteinander verbunden sind, als Zellaggregat betrachtet wird; dann wird der Aggregationsgrad der anorganischen Teilchen für mehrere Reihen bestimmt, und wird der größte Aggregationsgrad von den für die mehreren Reihen bestimmten Aggregationsgraden der anorganischen Teilchen als maximaler Aggregationsgrad definiert, wobei sich die oben beschriebene "Primärteilchengröße" auf die kleinste Länge von den Durchmessern, Breiten, Tiefen und Höhen der anorganischen Teilchen bezieht; und
wobei die Dichte der anorganischen Teilchen in dem ersten Bereich gemäß dem folgenden Verfahren bestimmt wird: zunächst wird ein Querschnittsbild der harten Überzugsschicht mit einem Transmissionselektronenmikroskop (TEM) oder einem Rastertransmissionselektronenmikroskop (STEM) bei einer 30.000- bis 100.000-fachen Vergrößerung aufgenommen und mit einem Bildverarbeitungsprogramm verarbeitet, um jede Zelle in dem Bild in Schwarz/Weiß zu binarisieren, wobei die anorganischen Teilchen mit einer höheren Dichte in schwarzer Farbe und das Bindemittelharz in weißer Farbe gezeigt sind; dann werden nach der Binarisierung die anorganischen Teilchen als schwarze Bereiche ausgedrückt und das Bindemittelharz wird als weiße Bereiche ausgedrückt; wobei in den Zellen, die in dem binarisierten Bild erscheinen, jede Zelle in einer Reihe als zu einem schwarzen oder weißen Bereich gehörend eingestuft wird, wobei eine Reihe mehrere Zellen umfasst, die in der Richtung orthogonal zu der Filmstärkenrichtung der harten Überzugsschicht angeordnet sind, um den Prozentsatz an Zellen, die als zu schwarzen Bereichen gehörend bestimmt wurden, an der Gesamtzahl der Zellen in der Reihe zu bestimmen, und wobei die Dichte der anorganischen Teilchen in dem zweiten Bereich auf die gleiche Weise bestimmt wird wie bei der Dichte der anorganischen Teilchen in dem ersten Bereich, mit der Ausnahme, dass die Dichte der anorganischen Teilchen in dem zweiten Bereich bestimmt wird, indem der oben beschriebene Prozentsatz für mindestens fünf Reihen in verschiedenen Tiefen in dem zweiten Bereich bestimmt und das arithmetische Mittel der erlangten Prozentsätze berechnet wird.

2. Funktioneller Film (10, 20) nach Anspruch 1, wobei sich mindestens ein Teil der anorganischen Teilchen (14) an der Grenzfläche zwischen der harten Überzugsschicht (12) und der funktionellen Schicht (16) befindet und eng an der funktionellen Schicht (16) angebracht ist.

3. Funktioneller Film (10, 20) nach Anspruch 1 oder 2, wobei die harte Überzugsschicht (12) den ersten Bereich (R1), der eine Schichtzone beinhaltet, in der die Dichte der anorganischen Teilchen (14) 70 % oder mehr ist, und den zweiten Bereich (R2), in dem die Dichte der anorganischen Teilchen (14) 50 % oder weniger ist, umfasst.

4. Funktioneller Film (10, 20) nach Anspruch 1, 2 oder 3, wobei die Filmstärke der harten Überzugsschicht (12) 1 µm oder mehr ist.

5. Funktioneller Film (10, 20) nach Anspruch 1, 2, 3 oder 4, ferner umfassend ein lichtdurchlässiges Basismaterial (11) umfasst, das auf der anderen Seite der harten Überzugsschicht (12) gegenüber der Seite, auf der die funktionelle Schicht (16) bereitgestellt ist, bereitgestellt ist.

6. Polarisationsplatte (30), umfassend:
den funktionellen Film (10, 20) nach Anspruch 1, 2, 3 oder 4; und
einen Polarisator (31), der auf der anderen Seite der harten Überzugsschicht (12) in dem funktionellen Film (10, 20) gegenüber der Seite, auf der die funktionelle Schicht (16) bereitgestellt ist, bereitgestellt ist.

7. Polarisationsplatte (30) nach Anspruch 6, umfassend:
einen harten Überzugsfilm (15), der die harten Überzugsschicht (12) beinhaltet.

8. Bildanzeigevorrichtung (40), umfassend den funktionellen Film (10, 20) nach Anspruch 1 oder die Polarisationsplatte (30) nach Anspruch 6 oder 7.

9. Verwendung eines harten Überzugsfilms (15), umfassend mindestens eine harte Überzugsschicht (12), die ein Bindemittelharz (13) und mehrere anorganische Teilchen (14) enthält, die Siliciumdioxidteilchen sind, zum Bilden einer anorganischen funktionellen Schicht (16) auf der vorderen Oberfläche (12A) der harten Überzugsschicht (12), die die vordere Oberfläche (15A) des harten Überzugsfilms (15) bildet,
**dadurch gekennzeichnet, dass** die harte Überzugsschicht (12) einen ersten Bereich (R1), der Schichtzonen beinhaltet, die eine erste Schichtzone beinhalten, in der die Summe der Elementverhältnisse von Si- und O-Elementen 60 % oder mehr ist, und eine zweite Schichtzone, in der die Summe der Elementverhältnisse der Si- und O-Elemente weniger als 60 % ist, und eine Zone, in der die Dichte der anorganischen Teilchen (14) 60 % oder mehr ist, von der vorderen Oberfläche bis zu einer Tiefe von 100 nm in der harten Überzugsschicht, und einen zweiten Bereich (R2), in der der maximale Aggregationsgrad der anorganischen Teilchen (14) in dem zweiten Bereich 30 % oder weniger ist und die Dichte der anorganischen Teilchen (14) 59 % oder weniger ist, unterhalb einer Tiefe von 100 nm von der vorderen Oberfläche (12A) in der harten Überzugsschicht (12), aufweist,
wobei die Dichte der anorganischen Teilchen (14) in dem ersten und dem zweiten Bereich und der maximale Aggregationsgrad der anorganischen Teilchen (14) in dem zweiten Bereich wie spezifiziert in Anspruch 1 bestimmt werden.

10. Verwendung eines harten Überzugsfilms (15) nach Anspruch 9, wobei die harte Überzugsschicht (12) einen ersten Bereich aufweist, der eine Zone beinhaltet, in der die Dichte der anorganischen Teilchen 70 % oder mehr ist, und einen zweiten Bereich, in dem die Dichte der anorganischen Teilchen 50 % oder weniger ist.

11. Verwendung eines harten Überzugsfilms (15) nach Anspruch 9 oder 10, wobei die Filmstärke der harten Überzugsschicht (12) 1 µm oder mehr ist.

12. Verwendung eines harten Überzugsfilms (15) nach Anspruch 9, 10 oder 11, wobei der harte Überzugsfilm (15) ferner ein lichtdurchlässiges Basismaterial (11) umfasst, das auf der Rückseite gegenüber der vorderen Oberfläche der harten Überzugsschicht (12) bereitgestellt ist.

## Revendications

1. Film fonctionnel (10, 20) comprenant une couche de revêtement dur (12) contenant une résine liante (13) et plusieurs particules inorganiques (14), lesquelles sont des particules de silice, et une couche fonctionnelle (16) fixée étroitement à la surface avant (12A) de la couche de revêtement dur (12),
**caractérisé en ce que**
la couche fonctionnelle (16) est une couche inorganique et la couche de revêtement dur (12) comprend une première région (R1) qui inclut des zones de couche incluant une première zone de couche, dans laquelle la somme des rapports d'éléments des éléments Si et O est de 60 % ou plus, et une deuxième zone de couche, dans laquelle la somme des rapports d'éléments de Si et O est inférieure à 60 %, et une zone de couche, dans laquelle la densité des particules inorganiques (14) est de 60 % ou plus, à partir de la surface avant à une profondeur de 100 nm dans la couche de revêtement dur (12), et une deuxième région (R2), dans laquelle le degré d'agrégation maximal des particules inorganiques (14) est de 30 % ou moins, et la densité des particules inorganiques (14) est de 59 % ou moins, en dessous d'une profondeur de 100 nm à partir de la surface avant (12A) dans la couche de revêtement dur (12),
dans lequel le degré d'agrégation maximal des particules inorganiques (14) dans la deuxième région R2 est déterminé comme suit : dans les cellules apparaissant dans une image binarisée, le rapport d'une série de cellules reliées entre elles dans une longueur de trois fois ou plus la taille de particule primaire de la particule inorganique sur le nombre total de cellules dans une rangée est d'abord déterminé pour calculer le degré d'agrégation pour la rangée, où une rangée comprend plusieurs cellules agencées dans la direction orthogonale à la direction de l'épaisseur du film de la couche de revêtement dur, et une série de cellules reliées entre elles dans une longueur de trois fois ou plus la taille de particule primaire de la particule inorganique est considérée comme un agrégat de cellules ; puis, le degré d'agrégation de particules inorganiques est déterminé pour des rangées multiples, et le degré d'agrégation le plus important parmi les degrés d'agrégation de particules inorganiques déterminé pour les rangées multiples est défini en tant que le degré d'agrégation maximal, dans lequel la « taille de particule primaire » décrite ci-dessus se réfère à la longueur la plus petite parmi les diamètres, largeurs, profondeurs et hauteurs des particules inorganiques ; et
dans lequel la densité des particules inorganiques dans la première région est déterminée par le procédé suivant : tout d'abord, une image en section transversale de la couche de revêtement dur capturée à l'aide d'un microscope électronique à transmission (TEM) ou d'un microscope électronique à transmission et à balayage (STEM) à un grossissement de 30 000 à 100 000 fois est acquise et traitée par un programme logiciel de traitement d'image pour binariser chaque cellule dans l'image en noir/blanc, dans lequel les particules inorganiques ayant une densité supérieure sont représentées en noir et la résine liante est représentée en blanc ; puis, après la binarisation, les particules inorganiques sont exprimées sous forme de régions noires, et la résine liante est exprimée sous forme de régions blanches ; dans lequel dans les cellules apparaissant dans l'image binarisée, chaque cellule sur une rangée est classifiée comme appartenant à une région noire ou blanche, où une rangée comprend plusieurs cellules agencées dans la direction orthogonale à la direction d'épaisseur de film de la couche de revêtement dur, pour déterminer le pourcentage de cellules déterminées comme appartenant aux régions noires dans le nombre total de cellules sur la rangée, et dans lequel la densité des particules inorganiques dans la deuxième région est déterminée de la même manière que la densité des particules inorganiques dans la première région, excepté que la densité des particules inorganiques dans la deuxième région est déterminée par obtention du pourcentage décrit ci-dessus pour au moins cinq rangées à différentes profondeurs dans la deuxième région et par calcul de la moyenne arithmétique des pourcentages obtenus.

2. Film fonctionnel (10, 20) selon la revendication 1, dans lequel au moins une portion des particules inorganiques (14) sont situées dans l'interface entre la couche de revêtement dur (12) et la couche fonctionnelle (16), et sont étroitement fixées à la couche fonctionnelle (16).

3. Film fonctionnel (10, 20) selon la revendication 1 ou 2, dans lequel la couche de revêtement dur (12) comprend la première région (R1) qui inclut une zone de couche, dans laquelle la densité des particules inorganiques (14) est de 70 % ou plus, et la deuxième région (R2), dans laquelle la densité des particules inorganiques (14) est de 50 % ou moins.

4. Film fonctionnel (10, 20) selon la revendication 1, 2 ou 3, dans lequel l'épaisseur de film de la couche de revêtement dur (12) est de 1 µm ou plus.

5. Film fonctionnel (10, 20) selon la revendication 1, 2, 3 ou 4, comprenant en outre un matériau de base transmettant la lumière (11) disposé sur l'autre côté de la couche de revêtement dur (12), opposé au côté sur lequel la couche fonctionnelle (16) est disposée.

6. Plaque de polarisation (30) comprenant :
le film fonctionnel (10, 20) selon la revendication 1, 2, 3 ou 4 : et
un polariseur (31) disposé sur l'autre côté de la couche de revêtement dur (12) dans le film fonctionnel (10, 20), opposé au côté sur lequel la couche fonctionnelle (16) est disposée.

7. Plaque de polarisation selon la revendication 6, comprenant :
un film à revêtement dur (15) qui inclut la couche de revêtement dur (12).

8. Dispositif d'affichage d'image (40) comprenant le film fonctionnel (10, 20) selon la revendication 1 ou la plaque de polarisation (30) selon la revendication 6 ou 7.

9. Utilisation d'un film à revêtement dur (15) comprenant au moins une couche de revêtement dur (12) contenant une résine liante (13) et plusieurs particules inorganiques (14), lesquelles sont des particules de silice, pour former une couche fonctionnelle inorganique (16) sur la surface avant (12A) de la couche de revêtement dur (12), laquelle constitue la surface avant (15A) du film à revêtement dur (15),
**caractérisée en ce que** la couche de revêtement dur (12) a une première région (R1) qui inclut des zones de couche incluant une première zone de couche, dans laquelle la somme des rapports d'éléments des éléments Si et O est de 60 % ou plus, et une deuxième zone de couche, dans laquelle la somme des rapports d'éléments de Si et O est inférieure à 60 %, et une zone, dans laquelle la densité des particules inorganiques (14) est de 60 % ou plus, à partir de la surface avant à une profondeur de 100 nm dans la couche de revêtement dur, et une deuxième région (R2), dans laquelle le degré d'agrégation maximal des particules inorganiques (14) dans la deuxième région est de 30 % ou moins, et la densité des particules inorganiques (14) est de 59 % ou moins, en dessous d'une profondeur de 100 nm à partir de la surface avant (12A) dans la couche de revêtement dur (12),
dans laquelle la densité des particules inorganiques (14) dans les première et deuxième régions et le degré d'agrégation maximal des particules inorganiques (14) dans la deuxième région sont déterminés comme spécifié dans la revendication 1.

10. Utilisation d'un film à revêtement dur (15) selon la revendication 9, dans laquelle la couche de revêtement dur (12) a la première région qui inclut une zone, dans laquelle la densité des particules inorganiques est de 70 % ou plus, et la deuxième région, dans laquelle la densité des particules inorganiques est de 50 % ou moins.

11. Utilisation d'un film à revêtement dur (15) selon la revendication 9 ou 10, dans laquelle l'épaisseur de film de la couche de revêtement dur (12) est de 1 µm ou plus.

12. Utilisation d'un film à revêtement dur (15) selon la revendication 9, 10 ou 11, dans laquelle le film à revêtement dur (15) comprend en outre un matériau de base transmettant la lumière (11) disposé sur la surface arrière opposée à la surface avant de la couche de revêtement dur (12).
